# EUROPEAN PATENT APPLICATION

(11) **EP 4 709 125 A1**
(43) Date of publication of application: **11.03.2026**
(21) Application number: 25196153.8
(22) Date of filing: 15.08.2025
(51) Int. Cl.: H10K 59/80, H10K 50/85, H10K 50/858, H10K 102/00

(54) **DISPLAY DEVICE AND ELECTRONIC DEVICE INCLUDING THE SAME**

(30) Priority: 06.09.2024 KR 20240121323
(71) Applicant: Samsung Display Co., Ltd., Yongin-si, Gyeonggi-do 17113 (KR)
(72) Inventor: HAN, Jong Seok, 17113 Giheung-gu, Yongin-si, Gyeonggi-do (KR); KIM, Dal Ho, 17113 Giheung-gu, Yongin-si, Gyeonggi-do (KR); KIM, Ji Young, 17113 Giheung-gu, Yongin-si, Gyeonggi-do (KR); PARK, Eun Ji, 17113 Giheung-gu, Yongin-si, Gyeonggi-do (KR); SUNG, Hyang Ki, 17113 Giheung-gu, Yongin-si, Gyeonggi-do (KR); JEONG, Hee Seong, 17113 Giheung-gu, Yongin-si, Gyeonggi-do (KR)
(74) Representative: Dr. Weitzel & Partner

(57) **Abstract**

A display device and an electronic device including at least one display device are disclosed. The display device may include a substrate; a light emitting element on the substrate; a capping layer including a first capping layer arranged on the light emitting element and having a first refractive index, a second capping layer arranged on the first capping layer and having a second refractive index that is higher than the first refractive index, and a third capping layer arranged on the second capping layer and having a third refractive index that is lower than the second refractive index; and a first encapsulation layer on the capping layer, wherein a refractive index of the first encapsulation layer is higher than the third refractive index of the third capping layer, wherein the first capping layer and the second capping layer include different materials.

## Description

The present invention relates to a display device and an electronic device including the display device (e.g., at least one display device).

With the advancement of information technology, demands for display devices for displaying images in one or more suitable forms are increasing. For example, display devices are applied to one or more suitable electronic devices, such as smartphones, digital cameras, notebook computers, navigation devices, and/or smart televisions. The display devices may be flat panel display devices, such as liquid crystal display devices, field emission display devices, and/or organic light emitting display devices. Among these flat panel display devices, a light emitting display device includes a light emitting element that enables each pixel of a display panel to emit light by itself. Thus, the light emitting display device may display an image without a backlight unit to provide illumination to the display panel.

Currently, to increase the usability of organic light emitting display devices, research is being conducted on methods of improving light efficiency by effectively extracting light generated from a light emitting layer.

One or more aspects of embodiments of the present invention are directed toward a display device which may improve or enhance the light efficiency of pixels.

One or more aspects of embodiments of the present invention are directed toward an electronic device including a display device (e.g., at least one display device) as described in one or more embodiments.

The invention is described by the features of claim 1. The dependent claims describe preferred embodiments. Additional aspects of embodiments will be set forth in part in the description which follows and, in part, will be apparent from the description or may be learned by practice of the presented embodiments of the invention.

However, aspects and features of embodiments of the present invention are not restricted to the one set forth herein. The above and other aspects and features of the present invention will become more apparent to one of ordinary skill in the art to which the present invention pertains by referencing the detailed description of the present invention given.

According to the present invention, a display device includes a substrate; a light emitting element arranged on the substrate; a capping layer including a first capping layer located or arranged on the light emitting element and having a first refractive index, a second capping layer located or arranged on the first capping layer and having a second refractive index that is higher than the first refractive index, and a third capping layer located or arranged on the second capping layer and having a third refractive index that is lower than the second refractive index; and a first encapsulation layer located or arranged on the capping layer and having a higher refractive index than the third capping layer (e.g., a refractive index of the first encapsulation layer is higher than the third refractive index of the third capping layer), wherein the first capping layer and the second capping layer include different materials, the first refractive index of the first capping layer is in a range of about 1.65 to about 1.80, and a thickness of the first capping layer is smaller than a thickness of the second capping layer by about 20% or more. The capping layer may also be termed as a capping layer structure.

In one or more embodiments, a difference value between the second refractive index and the first refractive index may be about 0.2 or more, and a difference value between the second refractive index and the third refractive index may be about 0.2 or more.

In one or more embodiments, the second refractive index may have a value of (e.g., may be in a range of) about 1.9 to about 2.3.

In one or more embodiments, the third refractive index may be in a range of about 1.65 to about 1.80.

In one or more embodiments, the first capping layer, the second capping layer, and the third capping layer may be formed or arranged by a thermal evaporation process.

In one or more embodiments, the first capping layer and the third capping layer may include at least any one selected from among lithium fluoride (LiF), 8-quinolinolato lithium (Liq), aluminum(III) bis(2 methyl-8-quinolinato)-4-phenylphenolate (BAlq), and tris(8-hydroxyquinolinato)aluminium (Alq3).

In one or more embodiments, the second capping layer may include at least any one selected from among tris(8-hydroxyquinolinato)aluminium (Alq3), ZnSe, 2,5-bis(6'(2',2"-bipyridyl))-1,1-dimethyl-3,4-diphenylsilole, 4'-bis[N-(1-napthyl)-N-phenyl-amino] biphenyl (α-NPD), N,N'-diphenyl-N,N'-bis(3-methylphenyl)-1,1'-biphenyl-4,4'-diamine (TPD), and 1,1-bis[(di-4-tolylamino)phenyl]cyclohexane (TAPC).

In one or more embodiments, a thickness of the first capping layer may be smaller than each of a thickness of the second capping layer and a thickness of the third capping layer, and the thickness of the second capping layer may be greater than each of the thickness of the first capping layer and the thickness of the third capping layer.

In one or more embodiments, the first capping layer may have a thickness of about 7 nm (70 Å) to about 13 nm (130 Å).

In one or more embodiments, the third capping layer may have a thickness of about 20 nm (200 Å) to about 30 nm (300 Å).

In one or more embodiments, the second capping layer may have a thickness of about 35 nm (350 Å) to about 50 nm (500 Å).

In one or more embodiments, the display device may further include a second encapsulation layer located or arranged on the first encapsulation layer; and a third encapsulation layer located or arranged on the second encapsulation layer, wherein the second encapsulation layer includes an organic material, and a refractive index of the second encapsulation layer is lower than each of the refractive index of the first encapsulation layer and a refractive index of the third encapsulation layer.

In one or more embodiments, the first encapsulation layer may further include a first inorganic layer located or arranged on the third capping layer and having a fourth refractive index; a second inorganic layer located or arranged on the first inorganic layer and having a fifth refractive index that is higher than the fourth refractive index; a third inorganic layer located or arranged on the second inorganic layer and having a sixth refractive index that is higher than the fourth refractive index and that is lower than the fifth refractive index; and a fourth inorganic layer located or arranged on the third inorganic layer and having a seventh refractive index that is lower than the sixth refractive index.

In one or more embodiments, the first inorganic layer may have a thickness in a range of about 55 nm (550 Å) to about 95 nm (950 Å), and the fourth refractive index of the first inorganic layer may have a value of (e.g., may be in a range of) about 1.47 to about 1.67.

In one or more embodiments, the second inorganic layer may have a thickness in a range of about 40 nm (400 Å) to about 200 n (2000 Å), and the fifth refractive index of the second inorganic layer may have a value of (e.g., may be in a range of) about 1.7 to about 2.0.

In one or more embodiments, the third inorganic layer may have a thickness in a range of about 500 nm (5000 Å) to about 1100 nm (11000 Å), and the sixth refractive index of the third inorganic layer may have a value of (e.g., may be in a range of) about 1.52 to about 1.72.

In one or more embodiments, the fourth inorganic layer may have a thickness in a range of about 30 nm (300 Å) to about 110 nm (1100 Å), and the seventh refractive index of the fourth inorganic layer may have a value of (e.g., may be in a range of) about 1.42 to about 1.62.

In one or more embodiments, the first inorganic layer, the second inorganic layer, the third inorganic layer, and the fourth inorganic layer may include at least any one selected from among silicon oxide, silicon nitride, and silicon oxynitride, and oxygen content (e.g., amount) of the fourth inorganic layer may be higher than oxygen content (e.g., amount) of each of the first inorganic layer, the second inorganic layer, and the third inorganic layer.

In one or more embodiments, the light emitting element may include a first electrode arranged on the substrate, an intermediate layer arranged on the first electrode and including a light emitting layer, and a second electrode arranged on the intermediate layer, and the first capping layer may be located or arranged on the second electrode to contact the second electrode.

According to one or more embodiments of the present invention, an electronic device includes at least one display device, wherein the at least one display device includes: a substrate including a display area and a non-display area around (e.g., surrounding) the display area; a light emitting element arranged on the substrate; a capping layer including a first capping layer located or arranged on the light emitting element and having a first refractive index, a second capping layer located or arranged on the first capping layer and having a second refractive index that is higher than the first refractive index, and a third capping layer located or arranged on the second capping layer and having a third refractive index that is lower than the second refractive index; and a first encapsulation layer located or arranged on the capping layer and having a higher refractive index than the third capping layer (e.g., a refractive index of the first encapsulation layer is higher than the third refractive index of the third capping layer), wherein the first capping layer and the second capping layer include different materials, the first refractive index of the first capping layer is in a range of about 1.65 to about 1.80, and a thickness of the first capping layer is smaller than a thickness of the second capping layer by about 20% or more.

According to one or more embodiments of the present invention, the resonance of light emitted from the light-emitting element may be appropriately or suitably controlled or enhanced, and interfacial reflection that may occur on a path through which the light is emitted may be reduced. Accordingly, the display device according to one or more embodiments may improve or enhance light characteristics of pixels including light efficiency and solve the side color defects (or reduce a degree or occurrence of the side color defects) of the display device. For example, the resonance of light emitted from the light-emitting element may be effectively or suitably controlled or enhanced. This control may be achieved through the strategic arrangement of capping and encapsulation layers with varying refractive indices, which helps to manage the light path and reduce losses. In one or more embodiments, interfacial reflection that may occur along the path through which the light is emitted may be significantly reduced. This reduction in interfacial reflection may be to maintain the integrity and brightness of the emitted light. As a result, the display device may exhibit improved or enhanced light characteristics of pixels, including increased or enhanced light efficiency. Enhanced light efficiency refers to that more light generated by the light-emitting element is effectively utilized, leading to brighter and more vivid displays. Furthermore, these improvements may address and potentially resolve side color defects (or reduce a degree or occurrence of side color defects), which are often caused by unwanted reflections and scattering of light. By reducing the degree or occurrence of these side color defects, the overall display quality is significantly enhanced, providing a better visual experience for users.

However, aspects and features of embodiments of the present invention are not limited to those example embodiments herein, and one or more suitable other aspects and features are incorporated herein.

The above and other aspects and features of certain embodiments of the present invention will become more apparent and more readily appreciated from the following description of one or more embodiments, taken in conjunction with the accompanying drawings in which:
FIG. 1 is a schematic plan view of a display device according to one or more embodiments;
FIG. 2 is an equivalent circuit diagram of a pixel according to one or more embodiments;
FIG. 3 is a plan view illustrating the schematic arrangement of a plurality of pixels in a display area of FIG. 1;
FIG. 4 is a schematic cross-sectional view of a display device according to one or more embodiments, taken along the line X1-X1' of FIG. 3;
FIG. 5 is a schematic cross-sectional view of a display device according to one or more embodiments, taken along the line X1-X1' of FIG. 3;
FIG. 6 is a schematic view of a display device according to one or more embodiments;
FIG. 7 is an enlarged view of a capping layer and an encapsulation layer illustrated in FIG. 6;
FIG. 8 is a schematic view of a comparative example for comparison with a display device according to one or more embodiments;
FIG. 9 is a graph illustrating the white efficiency of a display device according to one or more embodiments with respect to the refractive indices of a first capping layer and a third capping layer of the display device;
FIG. 10 is a graph illustrating side color and white efficiency with respect to the thickness of a first capping layer of a display device according to one or more embodiments;
FIG. 11 is a graph illustrating side color and white efficiency with respect to the thickness of a third capping layer of a display device according to one or more embodiments;
FIG. 12 is a schematic view of a display device according to one or more embodiments;
FIG. 13 is an enlarged view of a capping layer and an encapsulation layer illustrated in FIG. 12; and
FIG. 14 is a schematic perspective view of an electronic device of one or more embodiments.
FIG. 15 is a block diagram of an electronic device according to one embodiment of the present invention.
FIG. 16 is a schematic diagram of an electronic device according to various embodiments of the present invention.

The subject matter of the present invention will be described more fully herein with reference to the accompanying drawings, in which one or more embodiments of the present invention are shown. The subject matter of the present invention may, however, be embodied in different forms and should not be construed as being limited to one or more embodiments set forth herein. Rather, these embodiments are provided as examples so that this disclosure will be thorough and complete, and will fully convey the aspects and features of the present invention to those skilled in the art.

It is also to be understood that if (e.g., when) a layer is referred to as being "on" another layer or substrate, it may be directly on the other layer or substrate, or one or more intervening layers may also be present therebetween. In contrast, if (e.g., when) a layer is referred to as being "directly on" another element, there may be no intervening layers present therebetween.

The same reference numbers indicate substantially the same components throughout the specification.

It is to be understood that, although the terms "first," "second," and/or the like may be used herein to describe one or more suitable elements, these elements should not be limited by these terms. These terms are used to distinguish one element from another element. For instance, a first element discussed herein could be termed a second element without departing from the scope of the present invention. Similarly, the second element could also be termed a first element.

In the present disclosure, it will be understood that the term "comprise(s)/comprising," "include(s)/including," or "have/has/having" specifies the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

In the attached drawings, the thickness of layers and regions may be exaggerated to effectively or suitably illustrate the technical contents of the present disclosure.

The utilization of "may," if (e.g., when) describing embodiments of the present invention, refers to "one or more embodiments of the present invention."

As utilized herein, the terms "substantially," "about," or similar terms are used as terms of approximation and not as terms of degree and are intended to account for the inherent deviations in measured or calculated values that would be recognized by those of ordinary skill in the art. "About" as used herein, is inclusive of the stated value and refers to being within an acceptable range of deviation for the particular value as determined by one of ordinary skill in the art, considering the measurement in question and the error associated with measurement of the particular quantity (e.g., the limitations of the measurement system). For example, "about" may refer to being within one or more standard deviations, or within ±30%, ±20%, ±10%, or ±5% of the stated value.

In the context of the present invention and unless otherwise defined, the terms "use," "using," and "used" may be considered synonymous with the terms "utilize," "utilizing," and "utilized," respectively.

Unless otherwise defined, all terms (including technical and scientific terms) used herein have substantially the same meaning as commonly understood by one of ordinary skill in the art to which the present invention pertains. It is also to be understood that terms defined in dictionaries that are generally available or generally used should be interpreted as having meanings consistent with the meanings in the context of the related art, and are expressly defined herein unless they are interpreted in an ideal or overly formal sense.

Hereinafter, embodiments of the present invention will be described in more detail with reference to the accompanying drawings.

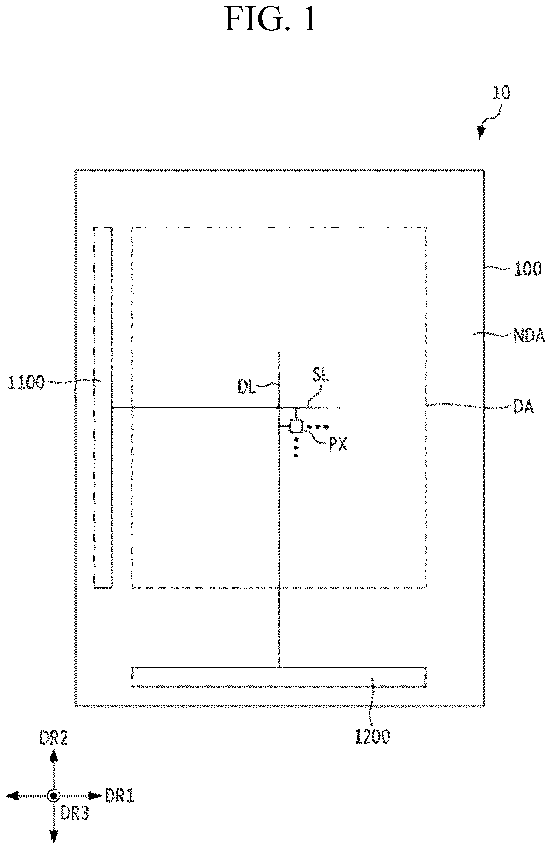

FIG. 1 is a schematic plan view of a display device 10 according to one or more embodiments.

Referring to FIG. 1, the display device 10 according to one or more embodiments may include a substrate 100 and pixels PX arranged on the substrate 100. The display device 10 may further include a scan driver 1100 and a data driver 1200 electrically connected to the pixels PX. The scan driver 1100 and the data driver 1200 may be arranged on the substrate 100, but embodiments of the present invention are not limited thereto. For example, at least one selected from among the scan driver 1100 and the data driver 1200 may be arranged on a circuit board (e.g., a flexible printed circuit board (FPCB)) electrically connected to pads arranged on the substrate 100.

The substrate 100 may be a base layer to manufacture or provide the display device 10 and may form or provide a support for a display panel including the pixels PX. The substrate 100 may include a display area DA and a non-display area NDA around the display area DA. The display area DA may be an area where the pixels PX are arranged and may be an area where an image is displayed by the pixels PX. The non-display area NDA may be an area other than the display area DA and may be arranged around the display area DA. For example, the non-display area NDA may be around (e.g., surround) the display area DA.

In FIG 1, a first direction DR1, a second direction DR2, and a third direction DR3 are defined. In one or more embodiments, the first direction DR1 may be a horizontal direction of the display device 10 (or the substrate 100), and the second direction DR2 may be a vertical direction of the display device 10. The third direction DR3 may be a thickness direction of the display device 10.

In FIG. 1, the substrate 100 and the display area DA may have a quadrangular shape (e.g., a substantially quadrangular shape) in plan view, but embodiments of the present invention are not limited thereto. For example, the shape of the substrate 100 and the display area DA may vary according to one or more embodiments. In one or more embodiments, in FIG. 1, corner portions of the substrate 100 and the display area DA may be angled. However, embodiments of the present invention are not limited thereto. For example, the substrate 100 and the display area DA may also include angled corner portions and/or rounded corner portions.

In the display area DA, the pixels PX and lines (or portions of the lines) connected to the pixels PX may be arranged. For example, the pixels PX, scan lines SL, and data lines DL may be arranged in the display area DA. In the description of one or more embodiments, "connection" may include electrical connection and/or physical connection. In FIG. 1, one pixel PX and one scan line SL and data line DL connected to the pixel PX are illustrated. However, a plurality of pixels PX and a plurality of scan lines SL and a plurality of data lines DL connected to the pixels PX may be arranged in the display area DA.

Each of the pixels PX may be further connected to additional lines. For example, each of the pixels PX may be further connected to a first power line to which a first power supply voltage is applied and a second power line to which a second power supply voltage is applied. The type (kind) or number of lines connected to each pixel PX may vary according to the configuration or arrangement of the pixel PX (e.g., the structure or operation method of a pixel circuit).

The lines connected to the pixels PX (e.g., portions of lines that extend from the display area DA to the non-display area NDA) may be arranged in the non-display area NDA. In one or more embodiments, the scan driver 1100 and the data driver 1200 may be arranged in the non-display area NDA.

The scan driver 1100 may be connected to the pixels PX through the scan lines SL. The scan driver 1100 may be to supply scan signals to the pixels PX. In one or more embodiments, the scan driver 1100 may be formed or arranged on the substrate 100 together with the pixels PX, but embodiments of the present invention are not limited thereto.

Although FIG. 1 discloses one or more embodiments in which the scan driver 1100 is arranged only on one side (e.g., a left side) of the display area DA, embodiments of the present invention are not limited thereto. For example, the scan driver 1100 may also be arranged on both sides (e.g., two opposing sides) (e.g., left and right sides) of the display area DA. In one or more embodiments, the scan driver 1100 may be arranged on a circuit board electrically connected to the pixels PX through pads arranged on the substrate 100.

The data driver 1200 may be connected to the pixels PX through the data lines DL. The data driver 1200 may be to supply data signals. In one or more embodiments, the data driver 1200 may be formed or arranged as an integrated circuit (IC) chip and may be arranged or mounted on the substrate 100. However, embodiments of the present invention are not limited thereto. For example, the data driver 1200 may also be arranged on a circuit board electrically connected to the pixels PX through pads arranged on the substrate 100.

In one or more embodiments, the display device 10 may be a light emitting display device, such as an organic light emitting display device including an organic light emitting diode, a quantum dot light emitting display device including a quantum dot light emitting layer, an inorganic light emitting display device including an inorganic semiconductor, and/or an ultrasmall light emitting display device including an ultrasmall light emitting diode, such as a micro- and/or nano-light emitting diode. However, embodiments of the present invention are not limited thereto. For example, the display device 10 may also be a display device of a type (kind) other than a light emitting display device. One or more embodiments in which the display device 10 is an organic light emitting display device are disclosed herein. However, the display device 10 according to one or more embodiments is not limited to an organic light emitting display device, and technical aspects and features of one or more embodiments to be described in more detail herein may be applicable to other types (kinds) of display devices.

The display device 10 may further include additional components. For example, the display device 10 may further include a timing controller electrically connected to the scan driver 1100 and the data driver 1200 and a power supply circuit electrically connected to the pixels PX, the scan driver 1100, and the data driver 1200.

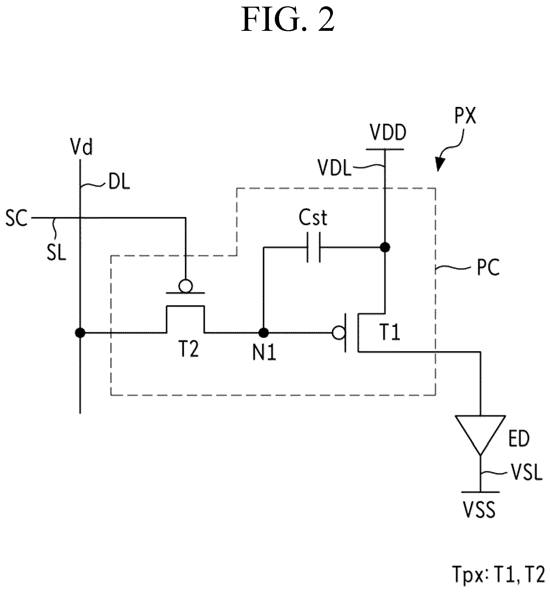

FIG. 2 is an equivalent circuit diagram of a pixel PX according to one or more embodiments. The pixel PX of FIG. 2 is disclosed as an example, and the structure or type (kind) of the pixel PX may vary according to one or more embodiments.

Referring to FIG. 2, the pixel PX may include a light emitting element ED and a pixel circuit PC connected to the light emitting element ED. The light emitting element ED may be a light source of the pixel PX and may be, for example, an organic light emitting diode. The pixel circuit PC may be to supply a driving current that corresponds to a data signal Vd to the light emitting element ED.

The pixel circuit PC may be connected to driving lines to which driving signals to drive the pixel PX are transmitted and power lines to which power supply voltages to drive the pixel PX are applied. For example, the pixel circuit PC may be connected to a scan line SL to which a scan signal SC is transmitted, a data line DL to which the data signal Vd is transmitted, a first power line VDL to which a first power supply voltage VDD (e.g., a high-potential pixel voltage) is applied, and a second power line VSL to which a second power supply voltage VSS (e.g., a low-potential pixel voltage) is applied.

The pixel circuit PC may include pixel transistors Tpx and a capacitor Cst. For example, the pixel circuit PC may include a first transistor T1, a second transistor T2, and the capacitor Cst.

The structure of the pixel circuit PC or the type (kind) and number of circuit elements that constitute the pixel circuit PC may vary according to one or more embodiments. For example, the pixel circuit PC may further include at least one other pixel transistor and/or at least one other capacitor. In one or more embodiments, although FIG. 2 illustrates an example in which all pixel transistors Tpx are positive type (kind) (p-type (kind)) transistors, embodiments of the present invention are not limited thereto. For example, at least one pixel transistor Tpx may be formed or provided as a negative type (kind) (n-type (kind)) transistor.

The pixel circuit PC may be to supply a driving current to the light emitting element ED in response to driving signals supplied from the scan driver 1100 and the data driver 1200. For example, the pixel circuit PC may be to supply a driving current to the light emitting element ED in response to the scan signal SC supplied from the scan driver 1100 through the scan line SL and the data signal Vd supplied from the data driver 1200 through the data line DL.

The first transistor T1 may be a driving transistor that is to control the driving current of the pixel PX in response to the voltage of a first node N1. The first transistor T1 may include a gate electrode connected to the first node N1, a first electrode connected to the first power line VDL, and a second electrode connected to the light emitting element ED. The first transistor T1 may be to control the driving current that flows to the light emitting element ED in response to the data signal Vd transmitted to the first node N1.

The second transistor T2 may be a switching transistor that is turned on in response to the scan signal SC. The second transistor T2 may include a gate electrode connected to the scan line SL, a first electrode connected to the data line DL, and a second electrode connected to the first node N1. The second transistor T2 may be turned on by the scan signal SC of a gate-on voltage transmitted to the scan line SL to connect the data line DL and the first node N1. Accordingly, the data signal Vd transmitted to the data line DL may be transmitted to the first node N1.

Depending on the type (kind) (e.g., a p-type (kind) or n-type (kind) transistor) and/or operating conditions of each of the first transistor T1 and the second transistor T2, the first electrode of each of the first transistor T1 and the second transistor T2 may be a source electrode or a drain electrode, and the second electrode may be an electrode different from the first electrode. For example, if (e.g., when) the first electrode of the first transistor T1 is a source electrode, the second electrode of the first transistor T1 may be a drain electrode.

The capacitor Cst may be a storage capacitor of the pixel PX and may store a voltage that corresponds to the data signal Vd (e.g., data voltage). The capacitor Cst may be connected between the gate electrode and the first electrode of the first transistor T1. For example, the capacitor Cst may be connected between the first node N1 and the first power line VDL. In one or more embodiments, the first transistor T1 may be an n-type (kind) transistor, and the capacitor Cst may be connected between the gate electrode and the second electrode of the first transistor T1.

The light emitting element ED may be connected between the pixel circuit PC and the second power line VSL. The light emitting element ED may include a first electrode (e.g., an anode or a pixel electrode), a second electrode (e.g., a cathode or a counter electrode) opposite to (e.g., facing) the first electrode, and a light emitting layer (e.g., an organic light emitting layer) between the first electrode and the second electrode. The first electrode of the light emitting element ED may be connected to the pixel circuit PC. The second electrode of the light emitting element ED may be connected to the second power line VSL. In one or more embodiments, the second electrode of the light emitting element ED may be a common electrode shared by a plurality of pixels PX. The light emitting element ED may be to emit light with a luminance that corresponds to the driving current during a period in which the driving current is supplied from the pixel circuit PC.

The light emitting element ED may be to emit light of a specific color. For example, the light emitting element ED of each pixel PX may be to emit red light, green light, or blue light or may be to emit red light, green light, blue light, or white light.

In one or more embodiments, the pixels PX of the display area DA may include first pixels that emit light of a first color, second pixels that emit light of a second color, and third pixels that emit light of a third color. At least one first pixel, at least one second pixel, and at least one third pixel adjacent to each other may form or arrange one unit pixel.

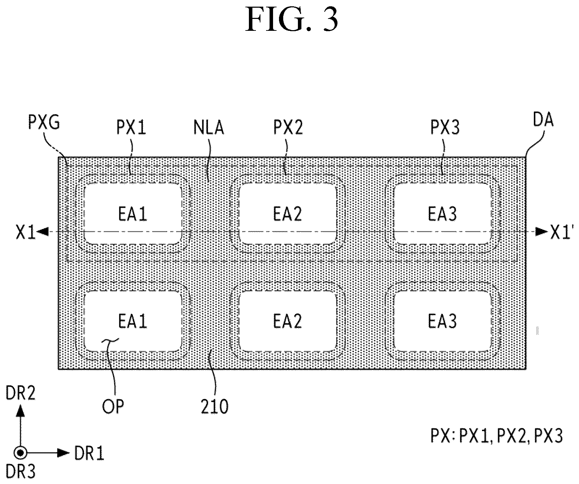

FIG. 3 is a plan view illustrating the schematic arrangement of a plurality of pixels PX in the display area DA of FIG. 1.

Referring to FIG. 3, the display area DA included in the display device 10 of one or more embodiments may include emission areas EA and a non-emission area NLA. The emission areas EA may be areas from which light is emitted, and the non-emission area NLA may entirely be around (e.g., surround) the emission areas EA.

The display device 10 of one or more embodiments may include a plurality of pixels PX in a portion that overlaps the display area DA. The pixels PX may include first pixels PX1, second pixels PX2, and third pixels PX3. The first pixels PX1, the second pixels PX2 and the third pixels PX3 may overlap the emission areas EA, respectively, and may be spaced and/or apart (e.g., spaced apart or separated) from each other with the non-emission area NLA between them. The non-emission area NLA may be to assist in preventing or reducing light emitted from emission areas EA that overlap the first pixels PX1, light emitted from emission areas EA that overlap the second pixels PX2, and light emitted from emission areas EA that overlap the third pixel PX3 from being mixed with each other.

The emission area EA that overlaps at least one first pixel PX1, the emission area EA that overlaps at least one second pixel PX2, and the emission area EA that overlaps at least one third pixel PX3 may form or provide a pixel group PXG. The pixel group PXG may be a smallest unit that emits white light. The type (kind) and/or number of emission areas EA that constitute the pixel group PXG may vary according to one or more embodiments.

A pixel defining layer 210 may be located or arranged in a portion that overlaps the non-emission area NLA in plan view. The pixel defining layer 210 may define openings OP in plan view, and the openings OP may be located or arranged in portions that overlap the emission areas EA. The pixel defining layer 210 may entirely be around (e.g., surround) the emission areas EA.

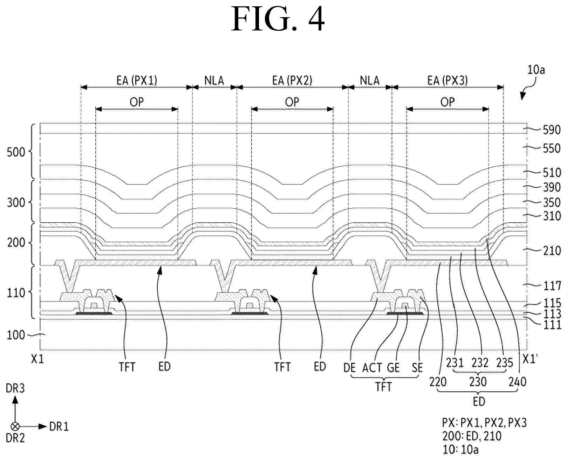

FIG. 4 is a schematic cross-sectional view of a display device 10a according to one or more embodiments, taken along the line X1-X1' of FIG. 3.

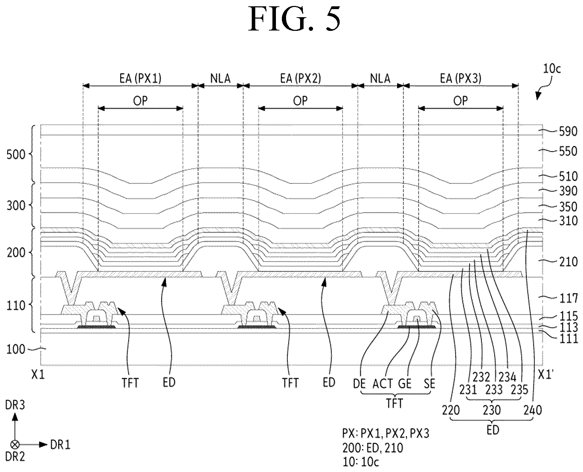

Referring to FIGS. 1 to 4, the display device 10 may include the display device 10a and a display device 10c (see FIG. 5) depending on the type (kind) of light emitting elements ED. The display device 10a and the display device 10c to be described in more detail herein may have substantially the same structure except for a difference in the stacked structure of the light emitting elements ED.

The display device 10a may include a substrate 100, a pixel circuit layer 110, a light emitting element layer 200, a capping layer 300, and an encapsulation layer 500. In one or more embodiments, the pixel circuit layer 110, the light emitting element layer 200, the capping layer 300, and the encapsulation layer 500 may be sequentially located or arranged on the substrate 100 along the third direction DR3.

The substrate 100 may be a lower substrate of the display device 10a. The substrate 100 may be composed of a single layer or multiple layers and may have rigid or flexible characteristics. In one or more embodiments, the substrate 100 may be a substrate that includes an insulating (e.g., electrically insulating) material, such as glass, and has rigid characteristics. In one or more embodiments, the substrate 100 may not be bent. In one or more embodiments, the substrate 100 may be a flexible substrate that includes polyimide and/or other insulating (e.g., electrically insulating) materials and may be bent, folded, rolled, and/or the like. In one or more embodiments, the substrate 100 may be bent. However, embodiments of the present invention are not limited thereto, and the type (kind), structure and/or material of the substrate 100 may vary according to one or more embodiments.

The pixel circuit layer 110 (e.g., a thin-film transistor layer) may be arranged on the substrate 100. The substrate 100 and the pixel circuit layer 110 may form or provide a backplane layer of the display device 10a.

The pixel circuit layer 110 may include circuit elements (e.g., the pixel transistors Tpx and the capacitor Cst of FIG. 2) that constitute a pixel circuit PC of each pixel PX and lines (e.g., the scan line SL, the data line DL, the first power line VDL, and the second power line VSL of FIG. 2). In one or more embodiments, the pixel circuit layer 110 may further include circuit elements of the scan driver 1100.

FIG. 4 shows one thin-film transistor TFT as an example of circuit elements that may be arranged in the pixel circuit layer 110 in each pixel PX. Each thin-film transistor TFT of FIG. 4 may be one of the pixel transistors Tpx provided in the pixel circuit PC of a corresponding pixel PX. For example, each thin-film transistor TFT of FIG. 4 may be the first transistor T1 of FIG. 2.

The pixel circuit layer 110 of one or more embodiments may include a buffer layer 111, the thin-film transistors TFT, a gate insulating layer 113, an interlayer insulating layer 115, and a via layer 117.

The buffer layer 111 may be located or arranged on the substrate 100. The buffer layer 111 may include an inorganic insulating (e.g., electrically insulating) material (e.g., insulator) and may be composed of a single layer or multiple layers. The buffer layer 111 may include an inorganic insulating (e.g., electrically insulating) material, for example, may include at least any one selected from among silicon oxide, silicon nitride, silicon oxynitride, silicon carbon nitride, titanium oxide, and aluminum oxide.

The thin-film transistors TFT may be located or arranged on the buffer layer 111. Each of the thin-film transistors TFT of one or more embodiments may include an active layer ACT, a gate electrode GE, a source electrode SE, and a drain electrode DE.

In one or more embodiments, each of the thin-film transistors TFT may not include (e.g., may exclude) the source electrode SE and/or the drain electrode DE, and a source region and/or a drain region of the active layer ACT may be connected to other circuit elements, conductive (e.g., electrically conductive) patterns, or lines to function as the source electrode and/or the drain electrode of the thin-film transistor TFT.

The active layer ACT may be located or arranged on the buffer layer 111. The active layer ACT may include a channel region that overlaps the gate electrode GE and a source region and a drain region located or arranged on both sides (e.g., two opposing sides) of the channel region in the first direction DR1. The source region and the drain region may be conductive (e.g., electrically conductive) regions formed or provided to have higher conductivity (e.g., electrical conductivity) than the channel region by doping or other methods. The source region of the active layer ACT may be connected to the source electrode SE, and the drain region of the active layer ACT may be connected to the drain electrode DE.

The active layer ACT may include a semiconductor material. For example, the active layer ACT may include polysilicon, amorphous (e.g., non-crystalline) silicon, an oxide semiconductor, and/or other semiconductor materials.

The gate insulating layer 113 may cover the active layer ACT. The gate insulating layer 113 may be to insulate the active layer ACT from the gate insulating layer GI. The gate insulating layer 113 may include an inorganic insulating (e.g., electrically insulating) material (e.g., insulators), for example, may include at least any one selected from among silicon oxide, silicon nitride, silicon oxynitride, silicon carbon nitride, titanium oxide, and aluminum oxide.

The gate electrode GE may be located or arranged on the gate insulating layer 113. The gate electrode GE may overlap the active layer ACT in the third direction DR3. The gate electrode GE may include a conductive (e.g., electrically conductive) material (e.g., conductor) and may be composed of a single layer or multiple layers.

For example, the gate electrode GE may include at least one selected from among copper (Cu), titanium (Ti), molybdenum (Mo), aluminum (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), and other metals, an alloy thereof, and/or other conductive (e.g., electrically conductive) materials (e.g., conductors).

The interlayer insulating layer 115 may cover the gate electrode GE. The interlayer insulating layer 115 may include an inorganic insulating (e.g., electrically insulating) material, for example, may include at least any one selected from among silicon oxide, silicon nitride, silicon oxynitride, silicon carbon nitride, titanium oxide, and aluminum oxide.

The source electrode SE and the drain electrode DE may be located or arranged on the interlayer insulating layer 115. Each of the source electrode SE and the drain electrode DE may include a conductive (e.g., electrically conductive) material and may be composed of a single layer or multiple layers. If (e.g., when) the source electrode SE and the drain electrode DE are arranged on substantially the same layer, they may be formed or arranged concurrently (e.g., simultaneously) by using substantially the same conductive (e.g., electrically conductive) material. Examples of the conductive (e.g., electrically conductive) material are omitted.

Each of the source electrode SE and the drain electrode DE may be connected to the active layer ACT through a contact hole that penetrates the gate insulating layer 113 and the interlayer insulating layer 115.

The drain electrode DE of one or more embodiments may be connected to a light emitting element ED through a contact hole that penetrates the via layer 117. Accordingly, the light emitting element ED may be electrically connected to the active layer ACT of a thin-film transistor TFT through the drain electrode DE. However, embodiments of the present invention are not limited thereto, and if (e.g., when) the thin-film transistor TFT is an n-type (kind) transistor, the source electrode SE of the thin-film transistor TFT may be connected to the light emitting element ED.

The via layer 117 may be located or arranged on the source electrode SE and the drain electrode DE. The via layer 117 may planarize a structure thereunder.

The via layer 117 may include an organic material and may be composed of a single layer or multiple layers. For example, the via layer 117 may include acrylic resin, epoxy resin, polyamide resin, benzocyclobutene (BCB), hexamethyldisiloxane (HMDSO), and/or other organic materials.

The light emitting element layer 200 may be arranged on the pixel circuit layer 110. The light emitting element layer 200 may include light emitting elements ED and a pixel defining layer 210. In one or more embodiments, the light emitting elements ED respectively included in a first pixel PX1, a second pixel PX2, and a third pixel PX3 may be to emit light of different wavelengths. For example, a light emitting element ED of the first pixel PX1 may be to emit light of a first color (e.g., red light), a light emitting element ED of the second pixel PX2 may be to emit light of a second color (e.g., green light), and a light emitting element ED of the third pixel PX3 may be to emit light of a third color (e.g., blue light).

Each of the light emitting elements ED may include a first electrode 220, an intermediate layer 230, and a second electrode 240 that are arranged sequentially.

The first electrode 220 may be located or arranged on the via layer 117 in a portion that overlaps an emission area EA where each of the first pixel PX1, the second pixel PX2, and the third pixel PX3 is located or arranged. The first electrodes 220 respectively included in the first pixel PX1, the second pixel PX2, and the third pixel PX3 may be spaced and/or apart (e.g., spaced apart or separated) from each other with the pixel defining layer 210 between them.

In one or more embodiments, the first electrode 220 may be a reflective electrode. For example, the first electrode 220 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a (e.g., any suitable) compound thereof.

In one or more embodiments, the first electrode 220 may further include a transparent or translucent electrode layer arranged on and/or under the reflective layer. In one or more embodiments, the transparent or translucent electrode layer of the first electrode 220 may include at least one material selected from among indium-tin oxide (ITO), indium-zinc oxide (IZO), zinc oxide (e.g., ZnO), indium oxide (e.g., InO and/or In₂O₃), indium-gallium oxide (IGO), and/or aluminum-zinc oxide (AZO). For example, the first electrode 220 may be, but is not limited to, a triple layer of an ITO layer, an Ag layer, and/or an ITO layer.

The pixel defining layer 210 may be located or arranged on the first electrodes 220 in a portion that overlaps a non-emission area NLA. The pixel defining layer 210 may define openings OP and expose the first electrodes 220 in portions that overlap the openings OP. The pixel defining layer 210 may cover edges of the first electrodes 220.

The pixel defining layer 210 may insulate (e.g., electrically insulate) the first electrodes 220 respectively included in the first pixel PX1, the second pixel PX2, and the third pixel PX3.

The pixel defining layer 210 may include an organic insulating (e.g., electrically insulating) material or an inorganic insulating (e.g., electrically insulating) material. For example, if (e.g., when) the pixel defining layer 210 includes an organic material, it may include polyimide, polyamide, acrylic resin, benzocyclobutene, hexamethyldisiloxane (HMDSO), and/or a phenolic resin. For example, if (e.g., when) the pixel defining layer 210 includes an inorganic material, it may include silicon oxide, silicon nitride, silicon oxynitride, silicon carbon nitride, titanium oxide, and/or aluminum oxide.

The intermediate layer 230 may be located or arranged on the first electrodes 220 and the pixel defining layer 210. The intermediate layer 230 may include a first functional layer 231, light emitting layers 232, and a second functional layer 235.

The first functional layer 231 may include at least one selected from among a hole transport layer and a hole injection layer. For example, the first functional layer 231 may include a hole transport layer or may include a hole transport layer and a hole injection layer. In one or more embodiments, at least one layer that forms or arrange the first functional layer 231 may be a common layer arranged over the entire display area DA. The detailed structure of the first functional layer 231 will be described in more detail herein.

The light emitting layers 232 may be located or arranged in portions that overlap the emission areas EA. The light emitting layers 232 may include a fluorescent material and/or a phosphorescent material that may emit light of a specific color. The light emitting layers 232 may include a low-molecular organic material and/or a high-molecular organic material.

In one or more embodiments, a light emitting layer 232 included in the light emitting element ED of the first pixel PX1 may be a red light emitting layer that emits red light, a light emitting layer 232 included in the light emitting element ED of the second pixel PX2 may be a green light emitting layer that emits green light, and a light emitting layer 232 included in the light emitting element ED of the third pixel PX3 may be a blue light emitting layer that emits blue light.

The second functional layer 235 may include at least one selected from among an electron transport layer and an electron injection layer. For example, the second functional layer 235 may include an electron transport layer or may include an electron transport layer and an electron injection layer. In one or more embodiments, at least one layer that forms or provides the second functional layer 235 may be a common layer arranged over the entire display area DA. The detailed structure of the second functional layer 235 will be described in more detail herein.

The second electrode 240 may be located or arranged on the intermediate layer 230. In one or more embodiments, the second electrode 240 may be a common layer arranged over the entire display area DA. For example, the second electrode 240 may be a common electrode.

In one or more embodiments, the second electrode 240 may be a transparent electrode or a translucent electrode. For example, the second electrode 240 may include a transparent conductive (e.g., electrically conductive) layer or a translucent conductive (e.g., electrically conductive) layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an (e.g., any suitable) alloy thereof. In one or more embodiments, the second electrode 240 may include, but is not limited to, silver (Ag), magnesium (Mg), or an alloy of silver (Ag) and magnesium (Mg). In one or more embodiments, the second electrode 240 may be, but is not limited to, a multilayer that further includes a conductive (e.g., electrically conductive) layer that overlaps the transparent conductive (e.g., electrically conductive) layer or the translucent conductive (e.g., electrically conductive) layer and including a transparent conductive (e.g., electrically conductive) oxide (TCO), such as indium-tin oxide (ITO), indium-zinc oxide (IZO), zinc oxide (e.g., ZnO), and/or indium oxide (e.g., InO and/or In₂O₃).

The capping layer 300 may be located or arranged on the light emitting element layer 200. The capping layer 300 may be to assist in efficiently or suitably emitting light generated from the light emitting elements ED toward the outside. The capping layer 300 may cover the entire second electrode 240 in the portions that overlap the emission areas EA and the non-emission area NLA.

The capping layer 300 may be composed of at least three multilayers sequentially stacked on the second electrode 240. The at least three layers may have different refractive indices. One or more embodiments related to the structure of the capping layer 300 will be described in more detail herein.

The encapsulation layer 500 may be located or arranged on the capping layer 300. The encapsulation layer 500 may block the penetration (or reduce a degree or occurrence of the penetration) of moisture and/or oxygen into the light emitting element layer 200 and/or the like and may alleviate electrical and/or physical impacts (or reduce a degree or occurrence of electrical and/or physical impacts) on the pixel circuit layer 110, the light emitting element layer 200, and/or the like.

The encapsulation layer 500 may be formed or arranged as a stacked structure of an organic layer and an inorganic layer. For example, the encapsulation layer 500 may include a first encapsulation layer 510, a second encapsulation layer 550, and a third encapsulation layer 590.

The first encapsulation layer 510 and the third encapsulation layer 590 may act or serve to prevent the penetration (or reduce a degree or occurrence of the penetration) of moisture and/or oxygen and may include an inorganic insulating (e.g., electrically insulating) material. For example, the first encapsulation layer 510 and the third encapsulation layer 590 may include silicon oxide, silicon nitride, silicon oxynitride, silicon carbon nitride, titanium oxide, and/or aluminum oxide. However, embodiments of the present invention are not limited thereto, and all inorganic insulating (e.g., electrically insulating) materials that are generally available or generally used in the encapsulation layer 500 may be included.

In one or more embodiments, the first encapsulation layer 510 may be composed of a single layer or multiple layers. If (e.g., when) the first encapsulation layer 510 has multiple layers, the multiple layers may have different refractive indices. One or more embodiments related to the structure of the encapsulation layer 500 will be described in more detail herein.

FIG. 5 is a schematic cross-sectional view of a display device 10c according to one or more embodiments, taken along the line X1-X1' of FIG. 3. The light emitting elements ED included in the display device 10c of FIG. 5 may have a different stacked structure from the light emitting elements ED included in the display device 10a of FIG. 4. A description of common structures of the display device 10a and the display device 10c may not be provided, and differences will be described in more detail herein.

Referring to FIGS. 1 to 5, the light emitting elements ED included in the display device 10c may have a tandem structure including at least two or more light emitting layers. In FIG. 5, the light emitting elements ED having a 2-tandem structure including two light emitting layers are illustrated. However, each of the light emitting elements ED may also be formed or arranged in a three or more-tandem structure including three or more light emitting layers.

An intermediate layer 230 of the light emitting elements ED included in the display device 10c may include a first functional layer 231, first light emitting layers 232, a third functional layer 233, second light emitting layers 234, and a second functional layer 235. Because the light emitting elements ED included in the display device 10c include the first light emitting layers 232 and the second light emitting layers 234, the amount of light generated from each of the light emitting elements ED may be greater than that in a display device not including a tandem structure. A description of the first functional layer 231 and the second functional layer 235 as described herein may not be provided in more detail.

In one or more embodiments, a light emitting layer 232 and a second light emitting layer 234 included in a light emitting element ED of a first pixel PX1 may be red light emitting layers that are to emit red light, a light emitting layer 232 and a second light emitting layer 234 included in a light emitting element ED of a second pixel PX2 may be green light emitting layers that are to emit green light, and a light emitting layer 232 and a second light emitting layer 234 included in a light emitting element ED of a third pixel PX3 may be blue light emitting layers that are to emit blue light.

The third functional layer 233 may be located or arranged between the light emitting layer 232 and the second light emitting layer 234 of each of the light emitting elements ED. In one or more embodiments, the third functional layer 233 may include a charge generation layer. The charge generation layer may inject charges into the light emitting layer 232 and the second light emitting layer 234 of each of the light emitting elements ED and may control a charge balance between the light emitting layer 232 and the second light emitting layer 234. In one or more embodiments, the charge generation layer may be a common layer arranged over the entire display area DA.

In one or more embodiments, the third functional layer 233 may further include a hole injection layer. In one or more embodiments, the hole injection layer of each of the light emitting elements ED may be individually located or arranged in each pixel area that corresponds to each pixel PX.

The display device 10 of one or more embodiments may have a top emission structure, and light generated from the light emitting element layer 200 may be emitted to the outside through the capping layer 300 and the encapsulation layer 500. The light generated from the light emitting element layer 200 may pass through each interlayer interface while passing through the capping layer 300 and the encapsulation layer 500. In one or more embodiments, the light may pass through each interlayer interface or may be reflected without passing through the interlayer interface. The interface reflection of light may be repeated between layers, and multiple rays of light may resonate during the repeated reflection process.

In one or more embodiments, a light efficiency improvement or enhancement effect due to the resonance of light emitted from the light emitting elements ED may be increased or enhanced or optimized by adjusting the materials, refractive indices, and/or thicknesses of the capping layer 300 and the encapsulation layer 500 located or arranged on a path through which the light generated from the light emitting elements ED is emitted. The refractive indices may be measured at a visible light wavelength (e.g., 380 nm to 780 nm), and the thicknesses may have substantially the same meaning as heights.

For example, the greater the difference in refractive index between two layers that form or provide an interface among the layers included in the capping layer 300 and the layers included in the encapsulation layer 500 is, the greater the reflectivity of the interface may be, and thus the higher the possibility of occurrence of resonance may be.

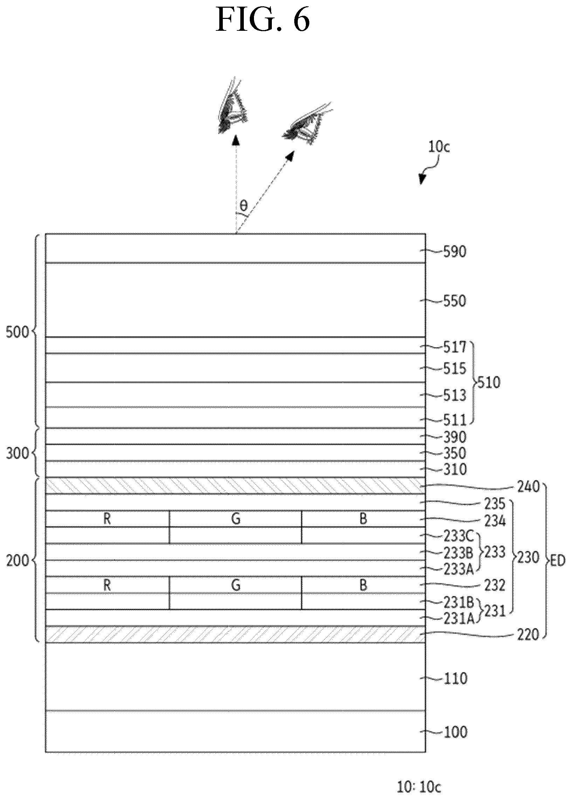

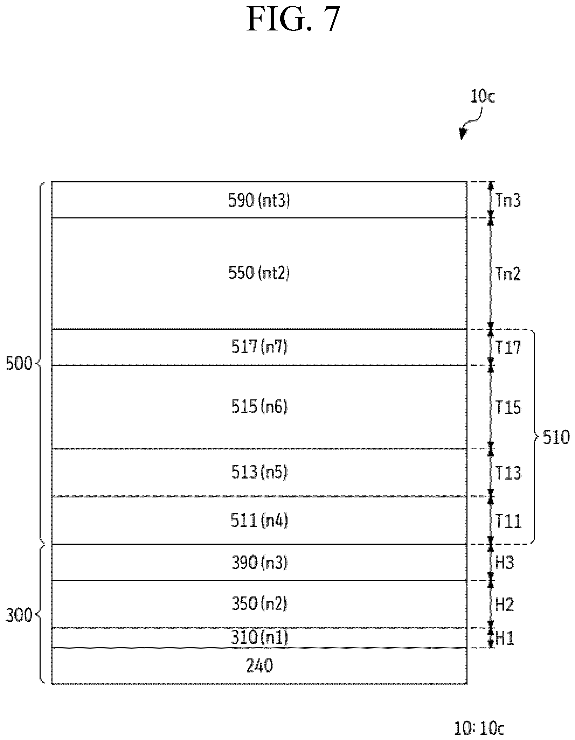

FIG. 6 is a schematic view of a display device according to one or more embodiments. FIG. 7 is an enlarged view of a capping layer 300 and an encapsulation layer 500 as illustrated in FIG. 6.

In FIG. 6, the capping layer 300 and the encapsulation layer 500 located or arranged on the light emitting elements ED included in the display device 10c of FIG. 5 are illustrated. However, the structural characteristics and a light efficiency improvement or enhancement effect are not limited thereto. For example, in one or more embodiments, the light emitting elements ED may include a 1-tandem structure as illustrated in FIG. 4 or may include a 3-tandem structure.

A redundant description of a substrate 100, a pixel circuit layer 110, and a light emitting element layer 200 may not be provided, and the detailed structures of the light emitting element layer 200, the capping layer 300, and the encapsulation layer 500 may not be described in more detail herein.

Referring to FIGS. 1 to 7, in one or more embodiments, a first functional layer 231 may be a multilayer including a hole transport layer 231A and a first hole injection layer 231B. The hole transport layer 231A may be a common layer formed or arranged over the entire display area DA. The first hole injection layer 231B may be individually formed or arranged in an emission area EA that overlaps each of a first pixel PX1, a second pixel PX2, and a third pixel PX3.

In one or more embodiments, the first hole injection layer 231B may be improved or optimized according to the characteristics of a light emitting layer 232 formed or arranged in the emission area EA that overlaps each of the first pixel PX1, the second pixel PX2, and the third pixel PX3. For example, a thickness or material of the first hole injection layer 231B may be differentiated or improved or optimized to improve or enhance the light emitting characteristics of each of the light emitting layer 232 of the first pixel PX1, the light emitting layer 232 of the second pixel PX2, and the light emitting layer 232 of the third pixel PX3.

In one or more embodiments, a second functional layer 235 may be composed of a single layer or multiple layers including an electron transport layer. For example, the second functional layer 235 may include an electron transport layer or may include an electron transport layer and an electron injection layer.

In one or more embodiments, a third functional layer 233 may include an n-type (kind) charge generation layer 233A and a p-type (kind) charge generation layer 233B. The n-type (kind) charge generation layer 233A may be located or arranged between the first light emitting layers 232 and the p-type (kind) charge generation layer 233B, and the p-type (kind) charge generation layer 233B may be located or arranged between the n-type (kind) charge generation layer 233A and second light emitting layers 234. The n-type (kind) charge generation layer 233A and the p-type (kind) charge generation layer 233B may be common layers formed or arranged over the entire display area DA.

The n-type (kind) charge generation layer 233A may be to supply electrons to the first light emitting layers 232, and the p-type (kind) charge generation layer 233B may be to supply holes to the second light emitting layers 234. Accordingly, the third functional layer 233 may increase or enhance the light emission efficiency of the light emitting elements ED and lower the driving voltage of the light emitting elements ED.

In one or more embodiments, the third functional layer 233 may further include a second hole injection layer 233C that is arranged between the p-type (kind) charge generation layer 233B and each of the second light emitting layers 234. In one or more embodiments, the second hole injection layer 233C may be individually formed or arranged in the emission area EA that overlaps each of the first pixel PX1, the second pixel PX2, and the third pixel PX3.

In one or more embodiments, a thickness of the second hole injection layer 233C may be differentiated or improved or optimized to increase (or enhance) or maximize or increase (or enhance) a resonance effect of light emitted from each of the light emitting elements ED of the first pixel PX1, the second pixel PX2, and the third pixel PX3. Accordingly, the second hole injection layers 233C included in the light emitting elements ED of the first pixel PX1, the second pixel PX2 and the third pixel PX3 may have different thicknesses, and the thickness of each of the second hole injection layers 233C may be adjusted to match a resonance distance of light emitted from the light emitting elements ED of the first pixel PX1, the second pixel PX2 and the third pixel PX3. Other redundant descriptions of the light emitting element layer 200 may not be provided herein.

The display device 10 of one or more embodiments may include the capping layer 300 to which a resonance structure is applied in order to increase the ratio of light generated from the light emitting element layer 200 and emitted to the outside through a multilayer stacked structure.

The capping layer 300 of one or more embodiments may include a first capping layer 310, a second capping layer 350, and a third capping layer 390. An optical thickness of each of the first capping layer 310, the second capping layer 350, and the third capping layer 390 may be λ/4 or less of a maximum wavelength of visible light (about 780 nm). This is to prevent energy from being dispersed to a wavelength range other than visible light (or to reduce a degree to or occurrence of which energy disperses to a wavelength range other than visible light). The dispersion of energy to a wavelength range other than visible light may occur if (e.g., when) an appropriate or suitable optical thickness is not designed. Accordingly, an optical thickness range of each layer may be a major factor in forming or arranging a resonance structure.

In one or more embodiments, it is desirable that a difference in refractive index between the first capping layer 310, the second capping layer 350, and the third capping layer 390 is relatively large. This is because the greater the difference in refractive index between the layers is, the greater the reflectivity formed between interfaces may be, and the greater the reflectivity is, the higher the possibility of occurrence of resonance may be. However, greater reflectivity refers to reflectivity within an appropriate or suitable range, and the reflectivity that increases beyond the appropriate or suitable range may cause reflection defects. Accordingly, designing the refractive index of each layer to be within an appropriate or suitable range may be a major factor in forming or arranging a resonance structure.

As described in one or more embodiments, the display device 10 of one or more embodiments may also solve a side color (VACS) defect that may occur on a light propagation path by adjusting the refractive index and thickness of each of the first capping layer 310, the second capping layer 350, and the third capping layer 390. The side color (VACS) may be measured by observing the display device 10 at angles (e.g., θ in FIG. 6) of 0°, 30°, 45°, and 60° with respect to the third direction DR3 normal (e.g., perpendicular) to the substrate 100. For example, whether there is a side color (VACS) defect may be determined by measuring a percentage by which color coordinates and a white efficiency value measured at an angle of each of 30°, 45°, and 60° have changed from color coordinates and a white efficiency value measured at 0° with respect to the third direction DR3 normal (e.g., perpendicular) to the substrate 100. The side color (VACS) defect may occur if (e.g., when) the dispersion of the color coordinates measured at 0°, 30°, 45°, and 60° is not within a reference range, but is located at the boundary of the reference range or outside the reference range.

In one or more embodiments, the first capping layer 310 may be located or arranged on the light emitting element layer 200. The first capping layer 310 may be located or arranged on a second electrode 240 to contact the second electrode 240.

The first capping layer 310 may include an organic compound, an inorganic chemical, and/or an organic-inorganic hybrid compound. For example, the first capping layer 310 may be a layer of at least any one selected from among LiF, Liq, aluminum(III) bis(2 methyl-8-quinolinato)-4-phenylphenolate (BAlq), and tris(8-hydroxyquinolinato)aluminium (Alq₃).

The first capping layer 310 may be formed or arranged by a thermal evaporation process in a process of manufacturing the display device 10. For example, the first capping layer 310 may be formed or arranged by applying heat to at least any one selected from among the materials as described in one or more embodiments to vaporize a target source and deposit the target source on the substrate 100.

The first capping layer 310 may reduce a surface plasmon polariton phenomenon which is mainly or predominantly formed at an interface between the light emitting element layer 200 and the first capping layer 310. For example, the surface plasmon polariton phenomenon may be a cause of a decrease in the light efficiency of the display device 10 due to electromagnetic waves radiated from a boundary surface of each layer. The surface plasmon polariton phenomenon may decrease as the permittivity (ε) of each layer decreases, and the permittivity (ε) may be proportional to the refractive index. For example, if (e.g., when) the first capping layer 310 has a low refractive index, the permittivity of the first capping layer 310 may decrease, thus reducing the surface plasmon polariton phenomenon. For example, if (e.g., when) the first capping layer 310 has a refractive index of about 1.85 or less, the surface plasmon polariton defect may be solved (or a degree or occurrence of the surface plasmon polariton defect may be reduced).

In one or more embodiments, the first capping layer 310 may have a certain refractive index and thickness range in order to maximize or increase the resonance between the light emitting element layer 200 and the encapsulation layer 500.

In one or more embodiments, a first refractive index n1 of the first capping layer 310 may be different from a second refractive index n2 of the second capping layer 350. For example, the first refractive index n1 of the first capping layer 310 may be lower than the second refractive index n2 of the second capping layer 350. Accordingly, the first capping layer 310 may be described as a low refractive layer of the capping layer 300. For example, if (e.g., when) the first capping layer 310 has a first refractive index n1 of about 1.65 to about 1.80, it may have the highest white efficiency value without a side color defect.

In one or more embodiments, if (e.g., when) a thickness H1 of the first capping layer 310 is in a range of about 7 nm (70 Å) to about 13 nm (130 Å), the display device 10 may have the highest white efficiency value without a side color defect. For example, if (e.g., when) the thickness H1 of the first capping layer 310 exceeds a value of about 13 nm (130 Å), the surface plasmon polariton phenomenon may decrease, but a resonance reduction may increase, thus reducing the white efficiency. If (e.g., when) the thickness H1 of the first capping layer 310 has a value of less than about 7 nm (70 Å), it may cause a side color defect.

In one or more embodiments, the second capping layer 350 may be located or arranged on the first capping layer 310. The first capping layer 310 and the second capping layer 350 may include different materials or may include materials having different contents (e.g., amounts) of a specific element.

The second capping layer 350 may include an organic compound, an inorganic chemical, and/or an organic-inorganic hybrid compound. For example, the second capping layer 350 may include at least one selected from among tris(8-hydroxyquinolinato)aluminium (Alq₃), ZnSe, 2,5-bis(6'(2',2"-bipyridyl))-1,1-dimethyl-3,4-diphenylsilole, 4'-bis[N-(1-napthyl)-N-phenyl-amino] biphenyl (α-NPD), N,N'-diphenyl-N,N'-bis(3-methylphenyl)-1,1'-biphenyl-4,4'-diamine (TPD), and 1,1-bis[(di-4-tolylamino)phenyl]cyclohexane (TAPC).

The second capping layer 350 may be formed or arranged by a thermal evaporation process in the process of manufacturing the display device 10. The second capping layer 350 may be formed or arranged by applying heat to at least any one selected from among the materials as described in one or more embodiments to vaporize a target source and deposit the target source on the substrate 100.

The second capping layer 350 may have a certain refractive index and thickness range in order to maximize or increase the resonance between the light emitting element layer 200 and the encapsulation layer 500.

In one or more embodiments, the second refractive index n2 of the second capping layer 350 may be different from the first refractive index n1 of the first capping layer 310 and a third refractive index n3 of the third capping layer 390. For example, the second refractive index n2 of the second capping layer 350 may be higher than the first refractive index n1 of the first capping layer 310 and the third refractive index n3 of the third capping layer 390. Accordingly, the second capping layer 350 may be described as a high refractive layer of the capping layer 300. For example, if (e.g., when) the second capping layer 350 has a second refractive index n2 of about 1.9 to about 2.3, it may have the highest white efficiency value without a side color defect.

In one or more embodiments, if (e.g., when) a thickness H2 of the second capping layer 350 is in a range of about 35 nm (350 Å) to about 50 nm (500 Å), the display device 10 may have the highest white efficiency value without a side color defect. For example, if (e.g., when) the thickness H2 of the second capping layer 350 exceeds a value of about 50 nm (500 Å) or is less than a value of about 35 nm (350 Å), it may cause a decrease in white efficiency and/or cause a side color defect.

In one or more embodiments, the third capping layer 390 may be located or arranged on the second capping layer 350. The third capping layer 390 and the second capping layer 350 may include different materials or may include materials having different contents (e.g., amounts) of a specific element.

The third capping layer 390 may include an organic compound, an inorganic chemical, and/or an organic-inorganic hybrid compound. For example, the third capping layer 390 may be a layer of at least any one selected from among LiF, Liq, aluminum(III) bis(2 methyl-8-quinolinato)-4-phenylphenolate (BAlq), and tris(8-hydroxyquinolinato)aluminium (Alq₃). The third capping layer 390 may have substantially the same material as the first capping layer 310, but embodiments of the present invention are not limited thereto.

In one or more embodiments, if (e.g., when) the first capping layer 310 and the third capping layer 390 have substantially the same material, the display device 10 may be relatively easily manufactured.

The third capping layer 390 may be formed or arranged by a thermal evaporation process in the process of manufacturing the display device 10. The third capping layer 390 may be formed or arranged by applying heat to at least any one selected from among the materials as described in one or more embodiments to vaporize a target source and deposit the target source on the substrate 100.

The third capping layer 390 may have a certain refractive index and thickness range in order to maximize or increase the resonance between the light emitting element layer 200 and the encapsulation layer 500.

In one or more embodiments, the third refractive index n3 of the third capping layer 390 may be different from the second refractive index n2 of the second capping layer 350. For example, the third refractive index n3 of the third capping layer 390 may be lower than the second refractive index n2 of the second capping layer 350, and the third refractive index n3 of the third capping layer 390 and the first refractive index n1 of the first capping layer 310 may have similar values. Accordingly, the third capping layer 390 may be described as a low refractive layer of the capping layer 300. For example, if (e.g., when) the third capping layer 390 has a third refractive index n3 of about 1.65 to about 1.80, the display device 10 may have the highest white efficiency value without a side color defect. For example, a difference value between the third refractive index n3 of the third capping layer 390 and the second refractive index n2 of the second capping layer 350 may be, but is not limited to, about 0.2 or more.

In one or more embodiments, a thickness H3 of the third capping layer 390 may be greater than the thickness H1 of the first capping layer 310, and the thickness H1 of the first capping layer 310 may be smaller than the thickness H3 of the third capping layer 390 by about 20% or more. For example, if (e.g., when) the thickness H3 of the third capping layer 390 is in a range of about 20 nm (200 Å) to about 30 nm (300 Å), the display device 10 may have the highest white efficiency value without a side color defect. For example, if (e.g., when) the thickness H3 of the third capping layer 390 exceeds a value of about 30 nm (300 Å) or is less than a value of about 20 nm (200 Å), it may cause a decrease in white efficiency and/or cause a side color defect.

In the display device 10 of one or more embodiments, because the first capping layer 310 having low refractive characteristics, the second capping layer 350 having high refractive characteristics, and the third capping layer 390 having low refractive characteristics are sequentially stacked on the light emitting element layer 200, and each of the first capping layer 310, the second capping layer 350, and the third capping layer 390 is formed or arranged to have an improved or optimized optical thickness and refractive index range, the light efficiency of the display device 10 may be increased or enhanced, and the side color defects may be solved (or a degree or occurrence of the side color defects may be reduced).

The display device 10 of one or more embodiments may have the encapsulation layer 500 including a plurality of layers in order to maximize or increase the resonance between the light emitting element layer 200, the capping layer 300, and the encapsulation layer 500. The encapsulation layer 500 may include a first encapsulation layer 510, a second encapsulation layer 550, and a third encapsulation layer 590, and the first encapsulation layer 510 may include a first inorganic layer 511, a second inorganic layer 513, a third inorganic layer 515, and a fourth inorganic layer 517 that are stacked sequentially. The display device 10 of one or more embodiments may increase or enhance light efficiency and solve the side color defects (or reduce a degree or occurrence of the side color defects) by controlling refractive indices and thicknesses of the first inorganic layer 511, the second inorganic layer 513, the third inorganic layer 515, and the fourth inorganic layer 517. Redundant descriptions may not be provided.

In one or more embodiments, the first inorganic layer 511 may be located or arranged on the third capping layer 390 to contact the third capping layer 390. The first inorganic layer 511 may have barrier characteristics to prevent moisture penetration (or to reduce a degree or occurrence of moisture penetration) and may increase or enhance light efficiency by adding optical characteristics.

The first inorganic layer 511 may include an inorganic insulating (e.g., electrically insulating) material. For example, the first inorganic layer 511 may include at least any one selected from among silicon oxynitride and silicon oxide.

The first inorganic layer 511 may be formed or arranged by a chemical vapor deposition process in the process of manufacturing the display device 10.

The first inorganic layer 511 may have a certain refractive index and thickness range in order to maximize or increase the resonance in the light emitting element layer 200, the capping layer 300, and the encapsulation layer 500.

In one or more embodiments, if (e.g., when) the first inorganic layer 511 has a thickness T11 of about 55 nm (550 Å) to about 95 nm (950 Å) and a fourth refractive index n4 of about 1.47 to about 1.67, the display device 10 may have the highest white efficiency value without a side color defect. The first inorganic layer 511 may have a relatively low refractive index among the layers of the first encapsulation layer 510. Accordingly, the first inorganic layer 511 may be described as a low refractive layer of the first encapsulation layer 510. For example, the fourth refractive index n4 of the first inorganic layer 511 may be lower than the third refractive index n3 of the third capping layer 390, but embodiments of the present invention are not limited thereto.

In one or more embodiments, the second inorganic layer 513 may be located or arranged on the first inorganic layer 511 to contact the first inorganic layer 511. The second inorganic layer 513 may have barrier characteristics to prevent moisture penetration (or to reduce a degree or occurrence of moisture penetration) and may increase or enhance light efficiency by adding optical characteristics.

The second inorganic layer 513 may include an inorganic insulating (e.g., electrically insulating) material. For example, the second inorganic layer 513 may include at least any one selected from among silicon nitride and silicon oxynitride.

The second inorganic layer 513 may be formed or arranged by a chemical vapor deposition process in the process of manufacturing the display device 10.

The second inorganic layer 513 may have a certain refractive index and thickness range in order to maximize or increase the resonance in the light emitting element layer 200, the capping layer 300, and the encapsulation layer 500. A thickness T13 and a fifth refractive index n5 of the second inorganic layer 513 may be different from the thickness T11 and the fourth refractive index n4 of the first inorganic layer 511.

In one or more embodiments, if (e.g., when) the second inorganic layer 513 has a thickness T13 of about 40 nm (400 Å) to about 200 nm (2000 Å) and a fifth refractive index n5 of about 1.7 to about 2.0, the display device 10 may have the highest white efficiency value without a side color defect. The second inorganic layer 513 may have a relatively high refractive index among the layers of the first encapsulation layer 510. Accordingly, the second inorganic layer 513 may be described as a high refractive layer of the first encapsulation layer 510. For example, the fifth refractive index n5 of the second inorganic layer 513 may be higher than the fourth refractive index n4 of the first inorganic layer 511, and a difference value between the fourth refractive index n4 of the first inorganic layer 511 and the fifth refractive index n5 of the second inorganic layer 513 may be, but is not limited to, about 0.2 or more.

In one or more embodiments, the third inorganic layer 515 may be located or arranged on the second inorganic layer 513 to contact the second inorganic layer 513. The third inorganic layer 515 may have barrier characteristics to prevent moisture penetration (or to reduce a degree or occurrence of moisture penetration) and may increase or enhance light efficiency by adding optical characteristics.

The third inorganic layer 515 may include an inorganic insulating (e.g., electrically insulating) material. For example, the third inorganic layer 515 may include at least any one selected from among silicon nitride and silicon oxide.

The third inorganic layer 515 may be formed or arranged by a chemical vapor deposition process in the process of manufacturing the display device 10.

The third inorganic layer 515 may have a certain refractive index and thickness range in order to maximize or increase the resonance in the light emitting element layer 200, the capping layer 300, and the encapsulation layer 500. A thickness T15 and a sixth refractive index n6 of the third inorganic layer 515 may be different from the thickness T13 and the fifth refractive index n5 of the second inorganic layer 513.

In one or more embodiments, if (e.g., when) the third inorganic layer 515 has a thickness T15 of about 500 nm (5,000 Å) to about 1100 nm (11,000 Å) and a sixth refractive index n6 of about 1.52 to about 1.72, the display device 10 may have the highest white efficiency value without a side color defect. The third inorganic layer 515 may have a relatively medium refractive index among the layers of the first encapsulation layer 510.

For example, the sixth refractive index n6 of the third inorganic layer 515 may be higher than the fourth refractive index n4 of the first inorganic layer 511 and lower than the fifth refractive index n5 of the second inorganic layer 513. Accordingly, the third inorganic layer 515 may be described as a mid-refractive layer of the first encapsulation layer 510. For example, a difference value between the fifth refractive index n5 of the second inorganic layer 513 and the sixth refractive index n6 of the third inorganic layer 515 may be, but is not limited to, about 0.2 or more.

In one or more embodiments, the fourth inorganic layer 517 may be located or arranged on the third inorganic layer 515 to contact the third inorganic layer 515.

The fourth inorganic layer 517 may include an inorganic insulating (e.g., electrically insulating) material. For example, the fourth inorganic layer 517 may include at least any one selected from among silicon oxynitride and silicon oxide. However, a content (e.g., amount) ratio of silicon (Si), oxygen (O), and nitrogen (N) included in the fourth inorganic layer 517 may be different from a content (e.g., amount) ratio of silicon (Si), oxygen (O), and nitrogen (N) included in the first inorganic layer 511, the second inorganic layer 513, and the third inorganic layer 515. For example, the content (e.g., amount) of oxygen (O) in the fourth inorganic layer 517 may be higher than the content (e.g., amount) of oxygen (O) in the first inorganic layer 511, the second inorganic layer 513, and the third inorganic layer 515. For example, the fourth inorganic layer 517 may include at least any one selected from among O-rich silicon oxynitride and O-rich silicon nitride.

The fourth inorganic layer 517 may be formed or arranged by a chemical vapor deposition process in the process of manufacturing the display device 10.

The fourth inorganic layer 517 may have a certain refractive index and thickness range in order to maximize or increase the resonance in the light emitting element layer 200, the capping layer 300, and the encapsulation layer 500. A thickness T17 and a seventh refractive index n7 of the fourth inorganic layer 517 may be different from the thickness T15 and the sixth refractive index n6 of the third inorganic layer 515.

In one or more embodiments, if (e.g., when) the fourth inorganic layer 517 has a thickness T17 of about 30 nm (300 Å) to about 110 nm (1100 Å) and a seventh refractive index n7 of about 1.42 to about 1.62, the display device 10 may have the highest white efficiency value without a side color defect. The seventh refractive index n7 of the fourth inorganic layer 517 may be relatively low among those of the layers of the first encapsulation layer 510. Accordingly, the fourth inorganic layer 517 may be described as a low refractive layer of the first encapsulation layer 510.

The second encapsulation layer 550 may be located or arranged on the first encapsulation layer 510. The second encapsulation layer 550 may planarize a structure thereunder and alleviate or reduce impact applied to the structure.

The second encapsulation layer 550 may include an organic material. For example, the second encapsulation layer 550 may include an organic material, such as a silicone resin, a silicone acrylic resin, an epoxy resin, and/or an acrylic resin. However, embodiments of the present invention are not limited thereto, and all organic materials that are generally available or generally used in the encapsulation layer 500 may be included.

In one or more embodiments, the second encapsulation layer 550 may be formed or arranged by applying monomers having flowability and then curing the monomer layer by using heat and/or ultraviolet light. In one or more embodiments, the second encapsulation layer 550 may be formed or arranged by applying a polymer-based material as described in one or more embodiments.

The second encapsulation layer 550 may have a refractive index nt2 of about 1.4 to about 1.5. Because the second encapsulation layer 550 includes an organic material, it may have a refractive index in a refractive index range of an organic material that is generally available or generally used, in addition to the foregoing range.

A thickness Tn2 of the second encapsulation layer 550 may be, but is not limited to, about 1000 nm (10000 Å) to about 5000 nm (50000 Å).

The third encapsulation layer 590 may be located or arranged on the second encapsulation layer 550 to contact the second encapsulation layer 550. The third encapsulation layer 590 may be formed or arranged by chemical vapor deposition in the process of manufacturing the display device 10.

The third encapsulation layer 590 may have a refractive index nt3 of about 1.7 to about 1.9. The refractive index nt3 of the third encapsulation layer 590 may be different from the refractive index nt2 of the second encapsulation layer 550 by about 0.2 or more, but embodiments of the present invention are not limited thereto.

In the display device 10 of one or more embodiments, because the first inorganic layer 511 having low refractive characteristics, the second inorganic layer 513 having high refractive characteristics, the third inorganic layer 515 having medium refractive characteristics, and the fourth inorganic layer 517 having low refractive characteristics and a high oxygen content (e.g., amount) are sequentially stacked on the capping layer 300 including the first capping layer 310, the second capping layer 350, and the third capping layer 390, and each of the first inorganic layer 511, the second inorganic layer 513, the third inorganic layer 515, and the fourth inorganic layer 517 is formed or arranged to have an improved or optimized optical thickness range and refractive index range, the light efficiency of the display device 10 may be increased or enhanced, and the side color defects may be solved (or a degree or occurrence of the side color defects may be reduced).

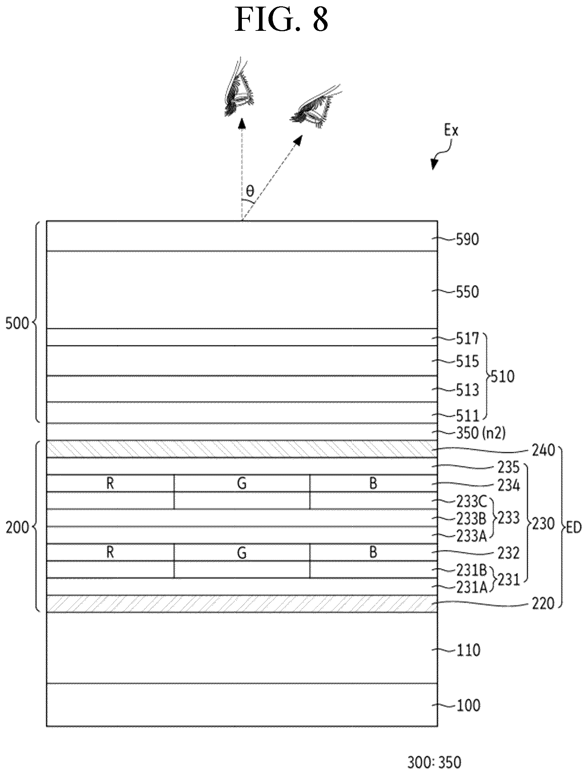

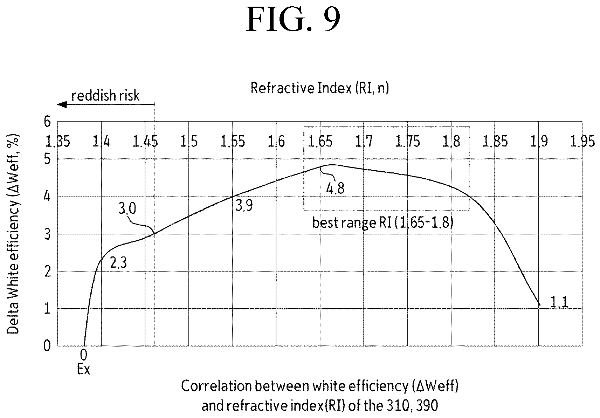

FIG. 8 is a schematic view of a comparative example for comparison with a display device according to one or more embodiments. FIG. 9 is a graph illustrating the white efficiency of a display device 10 according to one or more embodiments with respect to the refractive indices of a first capping layer 310 and a third capping layer 390 of the display device 10.

Referring to FIGS. 8 and 9, a capping layer 300 included in the comparative example Ex may be different from a capping layer 300 of the display device 10 in that it includes only a second capping layer 350. The second capping layer 350 included in the comparative example Ex may have substantially the same characteristics as a second capping layer 350 included in the display device 10. In one or more embodiments, a light emitting element layer 200 and an encapsulation layer 500 included in the comparative example Ex may have substantially the same characteristics as those of the display device 10.

For example, the second capping layer 350 of the comparative example Ex may have a second refractive index n2 of about 1.9 to about 2.3 and a thickness of about 35 nm (350 Å) to about 50 nm (500 Å).

The second capping layer 350 may include an organic material. For example, the second capping layer 350 may include at least one selected from among tris(8-hydroxyquinolinato)aluminium (Alq₃), ZnSe, 2,5-bis(6'(2',2"-bipyridyl))-1,1-dimethyl-3,4-diphenylsilole, 4'-bis[N-(1-napthyl)-N-phenyl-amino] biphenyl (α-NPD), N,N'-diphenyl-N,N'-bis(3-methylphenyl)-1,1'-biphenyl-4,4'-diamine (TPD), and 1,1-bis[(di-4-tolylamino)phenyl]cyclohexane (TAPC).

The graph of FIG. 9 illustrates the change in white efficiency (delta white efficiency △Weff(%)) of the display device 10 of one or more embodiments (a display device to which the first capping layer 310 and the third capping layer 390 are applied) based on the white efficiency of the comparative example Ex and illustrates the delta white efficiency △Weff(%) of the display device 10 with respect to the refractive indices (RI) of the first capping layer 310 and the third capping layer 390.

In the illustrated graph, thicknesses of the first capping layer 310, the second capping layer 350, and the third capping layer 390 included in the capping layer 300 and thicknesses of a plurality of layers included in the encapsulation layer 500 were measured after the thickness ranges as described in one or more embodiments were applied.

Referring to FIGS. 4 to 9, if (e.g., when) the white efficiency of the comparative example Ex not including the first capping layer 310 and the third capping layer 390 is defined as 0, the delta white efficiency ΔWeff(%) of the display device 10 of one or more embodiments including the first capping layer 310 and the third capping layer 390 may have a positive (+) value. For example, a white efficiency value, if (e.g., when) the first capping layer 310 and the third capping layer 390 having a refractive index (RI) range of about 1.4 to about 1.9 are applied, may be greater than a white efficiency value of the comparative example Ex not including the first capping layer 310 and the third capping layer 390 by about 1.1% or more.

For example, when the refractive indices (RI) of the first capping layer 310 and the third capping layer 390 were in a range of 1.4 to 1.46, the delta white efficiency value ΔWeff(%) increased by 2.3 to 3% compared to the white efficiency value of the comparative example Ex.

However, when the refractive indices (RI) of the first capping layer 310 and the third capping layer 390 were in a range of 1.46 or less, the display device 10 had a side color defect (e.g., a reddish risk). For example, when the refractive indices (RI) of the first capping layer 310 and the third capping layer 390 were in the range of 1.46 or less, light efficiency increased, but a side color defect may be included.

When the refractive indices (RI) of the first capping layer 310 and the third capping layer 390 included in the display device 10 were in a range of 1.46 to 1.55, the delta white efficiency value ΔWeff(%) increased by about 3 to about 3.9%, and no side color defect occurred.

When the refractive indices (RI) of the first capping layer 310 and the third capping layer 390 included in the display device 10 were in a range of 1.87 to 1.9, the delta white efficiency value ΔWeff(%) increased by about 1.1% or more, and no side color defect occurred. However, as described in one or more embodiments, the first capping layer 310 may be desired or required to have a refractive index (RI) of about 1.85 or less in order to solve a surface plasmon polariton defect (or to reduce a degree or occurrence of a surface plasmon polariton defect).

When the refractive indices (RI) of the first capping layer 310 and the third capping layer 390 included in the display device 10 were in a range of 1.65 to 1.80, the delta white efficiency value ΔWeff(%) increased by about 4.8%, and no side color defect occurred.

Therefore, a desired range of the refractive indices (RI) of the first capping layer 310 and the third capping layer 390 may be about 1.65 to about 1.80.

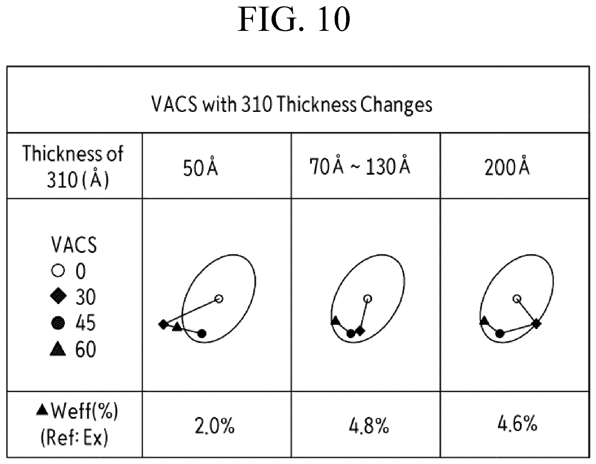

FIG. 10 is a graph illustrating side color and white efficiency with respect to the thickness of a first capping layer of a display device according to one or more embodiments.

Referring to FIG. 10 in addition to FIGS. 1 to 9, the degree of change in side color according to the thickness range of a first capping layer 310 (VACS with 310 thickness changes) may be measured as the degree of dispersion of color coordinates measured at an angle of each of 30°, 45°, and 60° based on color coordinate values measured at 0°.

For example, when the first capping layer 310 had a thickness H1 of about 50 Å, the delta white efficiency value ΔWeff(%) increased by about 2.0% compared to the white efficiency value of the comparative example Ex. However, it may be seen from a side color (VACS) image that the color dispersion of the values measured at the angles of 0°, 30°, 45°, and 60° was relatively large and that some of the measured values were outside an appropriate or suitable acceptable range represented by a circle. If (e.g., when) the color dispersion is outside the appropriate or suitable acceptable range represented by the circle as described in one or more embodiments, the display device may include a reddish risk or a bluish risk.

When the first capping layer 310 had a thickness H1 of about 200 Å, the delta white efficiency value ΔWeff(%) increased by about 4.6% compared to the white efficiency value of the comparative example Ex. However, it may be seen from a side color (VACS) image that the color dispersion of the values measured at the angles of 0°, 30°, 45°, and 60° was relatively large and that some of the measured values were at the boundary of an appropriate or suitable acceptable range represented by a circle. If (e.g., when) the color dispersion is at the boundary of the appropriate or suitable acceptable range represented by the circle as described in one or more embodiments, the display device may include a reddish risk or a bluish risk.

When the first capping layer 310 had a thickness H1 of about 70 Å to about 130 Å, it may be seen that the delta white efficiency value ΔWeff(%) increased by about 4.8% compared to the white efficiency value of the comparative example Ex and that the values measured at the angles of 0°, 30°, 45°, and 60° were within an appropriate or suitable acceptable range represented by a circle. In one or more embodiments, as is apparent from the values measured at the angles of 0°, 30°, 45° and 60°, relatively less color dispersion occurred.

Therefore, a desired range of the thickness H1 of the first capping layer 310 may be about 7 nm (70 Å) to about 13 nm (130 Å).

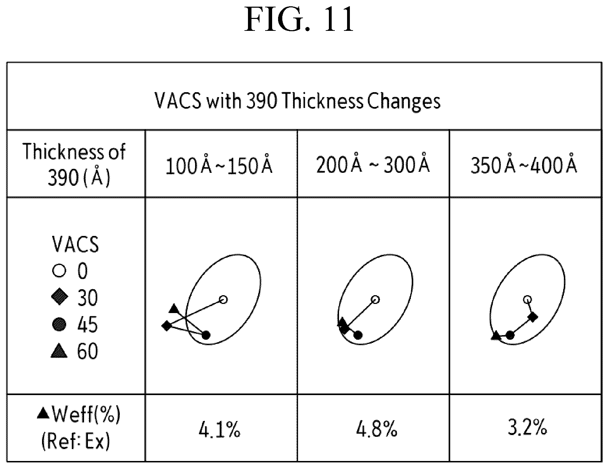

FIG. 11 is a graph illustrating side color and white efficiency with respect to the thickness of a third capping layer of a display device according to one or more embodiments.

Referring to FIG. 11 in addition to FIGS. 1 to 10, the degree of change in side color according to the thickness range of a third capping layer 390 (VACS with 390 thickness changes) may be measured as the degree of dispersion of color coordinates measured at an angle of each of 30°, 45°, and 60° based on color coordinate values measured at 0°.

For example, when the third capping layer 390 had a thickness H3 of about 10 nm (100) to 15 nm (150 Å), the delta white efficiency value ΔWeff(%) increased by about 4.1 % compared to the white efficiency value of the comparative example Ex. However, it may be seen from a side color (VACS) image that the color dispersion of the values measured at the angles of 0°, 30°, 45°, and 60° was relatively large and that some of the measured values were outside an appropriate or suitable acceptable range represented by a circle. If (e.g., when) the color dispersion is outside the appropriate or suitable acceptable range represented by the circle as described in one or more embodiments, the display device may include a reddish risk or a bluish risk.

When the third capping layer 390 had a thickness H3 of about 35 nm (350 Å) to about 40 nm (400 Å), the delta white efficiency value ΔWeff(%) increased by about 3.2% compared to the white efficiency value of the comparative example Ex. However, it may be seen from a side color (VACS) image that the color dispersion of the values measured at the angles of 0°, 30°, 45°, and 60° was relatively large and that some of the measured values were at the boundary of an appropriate or suitable acceptable range represented by a circle. If (e.g., when) the color dispersion is at the boundary of the appropriate or suitable acceptable range represented by the circle as described in one or more embodiments, the display device may include a reddish risk or a bluish risk.

When the third capping layer 390 had a thickness H3 of about 20 nm (200 Å) to about 30 nm (300 Å), it may be seen that the delta white efficiency value ΔWeff(%) increased by about 4.8% compared to the white efficiency value of the comparative example Ex and that the values measured at the angles of 0°, 30°, 45°, and 60° were within an appropriate or suitable acceptable range represented by a circle. In one or more embodiments, as apparent from the values measured at the angles of 0°, 30°, 45° and 60°, relatively less color dispersion occurred.

Therefore, a desired range of the thickness H3 of the third capping layer 390 may be about 20 nm (200 Å) to about 30 nm (300 Å).

For example, a display device 10 of one or more embodiments may include, on a second electrode 240 of light emitting elements ED, a capping layer 300 including a first capping layer 310 having a first refractive index n1 of about 1.65 to about 1.80 and a thickness H1 of about 7 nm (70 Å) to about 13 nm (130 Å), a second capping layer 350 having a second refractive index n2 of about 1.9 to about 2.3 and a thickness H2 of about 40 nm (400 Å) to 50 nm (500 Å), and a third capping layer 390 having a third refractive index n3 of about 1.65 to about 1.80 and a thickness H3 of about 20 nm (200 Å) to about 30 nm (300 Å).

In one or more embodiments, the display device 10 of one or more embodiments may include, on the capping layer 300, a first encapsulation layer 510 including a first inorganic layer 511 having a fourth refractive index n4 of about 1.47 to about 1.67 and a thickness T11 of about 55 nm (550 Å) to about 95 nm (950 Å), a second inorganic layer 513 having a fifth refractive index n5 of about 1.7 to about 2.0 and a thickness T13 of about 40 nm (400 Å) to about 200 nm (2000 Å), a third inorganic layer 515 having a sixth refractive index n6 of about 1.52 to about 1.72 and a thickness T15 of about 500 nm (5000 Å) to about 1100 nm (11000 Å), and a fourth inorganic layer 517 having a seventh refractive index n7 of about 1.42 to about 1.62 and a thickness T17 of about 30 nm (300 Å) to about 110 nm (1100 Å).

The display device 10 of one or more embodiments may improve or optimize the optical characteristics of pixels PX, including white efficiency and side color characteristics, by adjusting the refractive indices and thicknesses of the layers included in the capping layer 300 and the first encapsulation layer 510.

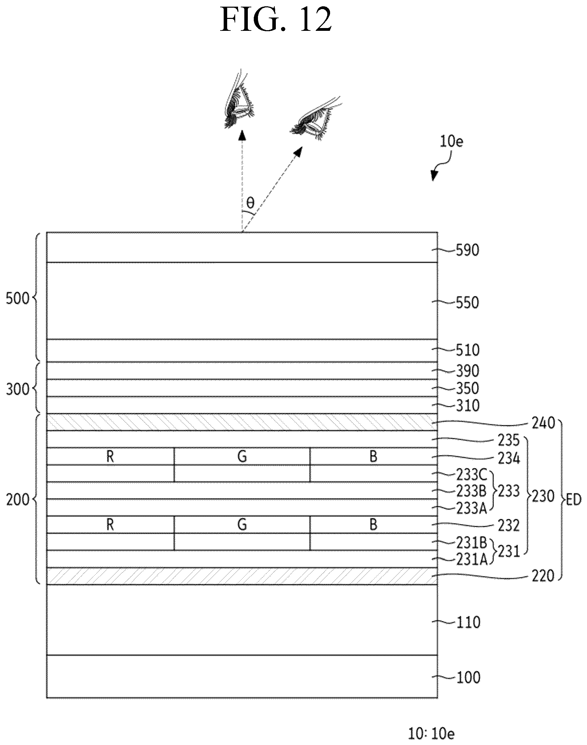

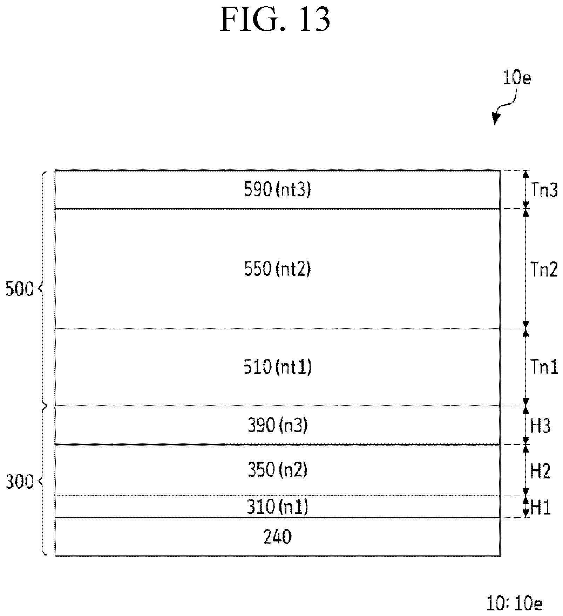

FIG. 12 is a schematic view of a display device 10e according to one or more embodiments. FIG. 13 is an enlarged view of a capping layer 300 and an encapsulation layer 500 in FIG. 12.

Referring to FIGS. 12 and 13, the first encapsulation layer 510 included in the display device 10e may have a different structure from the first encapsulation layer 510 included in the display device 10c of FIG. 6. A description of common structures included in the display device 10e and the display device 10c may not be provided, and differences will be described in more detail herein.

The encapsulation layer 500 included in the display device 10e may be located or arranged on the capping layer 300. The capping layer 300 may include a first capping layer 310, a second capping layer 350, and a third capping layer 390 and may have substantially the same characteristics as those described in FIGS. 4 to 11. Therefore, redundant descriptions may not be provided.

A first encapsulation layer 510 may be located or arranged on the third capping layer 390 to contact the third capping layer 390. The first encapsulation layer 510 may have barrier characteristics to prevent moisture penetration (or to reduce a degree or occurrence of moisture penetration) and may increase or enhance light efficiency by adding optical characteristics.

The first encapsulation layer 510 may include an inorganic insulating (e.g., electrically insulating) material. For example, the first encapsulation layer 510 may include at least any one selected from among silicon oxide, silicon nitride, silicon oxynitride, silicon carbon nitride, titanium oxide, and aluminum oxide.

The first encapsulation layer 510 may be formed or arranged by chemical vapor deposition and/or physical vapor deposition in a process of manufacturing the display device 10.

The first encapsulation layer 510 included in the display device 10e may be formed or arranged as a single layer. The first encapsulation layer 510 may be desired or required to have a certain thickness and refractive index range in order to maximize or increase a resonance phenomenon between a light emitting element layer 200 and the capping layer 300.

For example, the first encapsulation layer 510 may have a refractive index nt1 of about 1.47 to about 2.0, and a thickness Tn1 of the first encapsulation layer 510 may be in a range of about 40 nm (400 Å) to about 1400 nm (14000 Å). The refractive index nt1 of the first encapsulation layer 510 may be relatively high among those of the layers of the encapsulation layer 500. Therefore, the first encapsulation layer 510 may be described as a high refractive layer of the encapsulation layer 500.

A second encapsulation layer 550 may be located or arranged on the first encapsulation layer 510 to contact the first encapsulation layer 510. The second encapsulation layer 550 may have a refractive index nt2 of about 1.4 to about 1.5. Because the second encapsulation layer 550 includes an organic material, it may have a refractive index within a refractive index range of an organic material that is generally available or generally used, in addition to the foregoing range. The refractive index nt2 of the second encapsulation layer 550 may be relatively low among those of the layers of the encapsulation layer 500. Therefore, the second encapsulation layer 550 may be described as a low refractive layer of the encapsulation layer 500.

The refractive index nt2 of the second encapsulation layer 550 may be different from the refractive index nt1 of the first encapsulation layer 510 by about 0.2 or more.

A thickness Tn2 of the second encapsulation layer 550 may be, but is not limited to, about 1000 nm (10000 Å) to about 5000 nm (50000 Å).

A third encapsulation layer 590 may be located or arranged on the second encapsulation layer 550 to contact the second encapsulation layer 550. The third encapsulation layer 590 may have barrier characteristics to prevent moisture penetration (or to reduce a degree or occurrence of moisture penetration) and may increase or enhance light efficiency by adding optical characteristics.

The third encapsulation layer 590 may include an inorganic insulating (e.g., electrically insulating) material. For example, the third encapsulation layer 590 may include at least any one selected from among silicon oxide, silicon nitride, silicon oxynitride, silicon carbon nitride, titanium oxide, and aluminum oxide.

A refractive index nt3 of the third encapsulation layer 590 may be higher than the refractive index nt2 of the second encapsulation layer 550 and may be different from the refractive index nt2 of the second encapsulation layer 550 by about 0.2 or more. For example, the third encapsulation layer 590 may have a refractive index nt3 of about 1.7 to about 1.9.

A thickness Tn3 of the third encapsulation layer 590 may be, but is not limited to, about 500 nm (5000 Å) to 2000 nm (20000 Å).

In the display device 10e of one or more embodiments, because the first encapsulation layer 510 having relatively high refractive characteristics among the layers of the encapsulation layer 500, the second encapsulation layer 550 located or arranged on the first encapsulation layer 510 and having relatively low refractive characteristics among the layers of the encapsulation layer 500, and the third encapsulation layer 590 located or arranged on the second encapsulation layer 550 and having higher refractive characteristics than the second encapsulation layer 550 are sequentially stacked on the capping layer 300 including the first capping layer 310, the second capping layer 350 and the third capping layer 390, and each of the first encapsulation layer 510, the second encapsulation layer 550 and the third encapsulation layer 590 is formed to have an improved or optimized optical thickness, the light efficiency of the display device 10e may be increased or enhanced, and the side color defects may be solved (or a degree or occurrence of the side color defects may be reduced). Other redundant descriptions may not be provided.

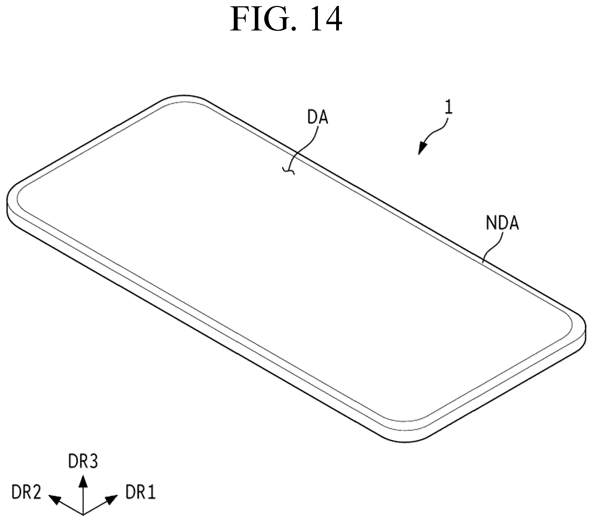

FIG. 14 is a perspective view of an electronic device to which a display device according to one or more embodiments is applied.

Although FIG. 14 illustrates a mobile electronic device 1, to which a display device 10 according to one or more embodiments is applied, as an example of the electronic device, the display device 10 according to one or more embodiments may be applicable to other electronic devices in addition to the mobile electronic device 1. For example, the display device 10 according to one or more embodiments may be applied to portable electronic devices which display moving images and/or still images, such as mobile phones, smartphones, smart watches, watch phones, mobile communication terminals, electronic notebooks, electronic books, portable multimedia players (PMPs), navigation devices, ultra mobile PCs (UMPCs), and/or tablets. In one or more embodiments, the display device 10 according to one or more embodiments may be used as a display screen in one or more suitable electronic devices, such as televisions, notebook computers, monitors, billboards, and/or Internet of things (IOT) devices.

According to one or more embodiments, it may be feasible to appropriately or suitably control or strengthen the resonance of light emitted from a light emitting element and reduce interface reflection that may occur on a path through which the light is emitted. Accordingly, a display device of one or more embodiments may improve or enhance optical characteristics of pixels, including light efficiency, and solve the side color defects (or reduce a degree or occurrence of the side color defects).

A display device, an electronic device, an electronic apparatus, a device for manufacturing substantially the same and/or any other relevant devices or components according to one or more embodiments of the present invention may be implemented by utilizing any suitable hardware, firmware (e.g., an application-specific integrated circuit), software, or a (e.g., any suitable) combination of software, firmware, and hardware. For example, the one or more components of the device may be provided on one integrated circuit (IC) chip or on separate IC chips. Further, the one or more components of the device may be implemented on a flexible printed circuit film, a tape carrier package (TCP), and/or a printed circuit board (PCB), or provided on one substrate. Further, the one or more components of the device may be a process or thread, running on one or more processors, in one or more computing devices, executing computer program instructions and interacting with other system components for performing the one or more functionalities described herein. The computer program instructions may be stored in a memory which may be implemented in a computing device using a standard memory device, such as, for example, a random access memory (RAM). The computer program instructions may also be stored in other non-transitory computer readable media, such as, for example, a CD-ROM, flash drive, and/or the like. Also, a person of skill in the art should recognize that the functionality of one or more computing devices may be combined or integrated into a single computing device, or the functionality of a particular computing device may be distributed across one or more other computing devices without departing from the scope of the present invention.

However, aspects and features of embodiments of the present invention are not restricted to the one set forth herein. The above and other aspects and features of certain embodiments of the present invention will become more apparent to one of ordinary skill in the art to which the present invention pertains by referencing the detailed description and the appended claims.

Although one or more embodiments of the present invention have been described with reference to the accompanying drawings, it will be apparent to those skilled in the art that the subject matter of the present invention may be embodied in different forms without departing from the scope as defined by the appended claims. Thus, the above embodiments are to be considered in all respects as illustrative and not restrictive.

One or more embodiments of the present invention have been described hereinabove with reference to the accompanying drawings, but it will be understood by one of ordinary skill in the art to which the present invention pertains that one or more suitable modifications and alterations may be made without departing from the scope of the present invention. Therefore, it should be understood that one or more embodiments described above are illustrative in all aspects and not restrictive.

Each suitable feature of the one or more embodiments of the present invention may be combined with each other partially or entirely. As will be clearly appreciated by those skilled in the art, technically one or more suitable interactions and operations may be feasible. Also, one or more suitable embodiments may be practiced individually or in combination.

In concluding the detailed description, those skilled in the art will appreciate that one or more suitable variations and modifications may be made to the described embodiments without substantially departing from the scope of the present invention. Therefore, the disclosed embodiments of the present invention are used in a generic and descriptive sense and not for purposes of limitation.

The display device according to one embodiment of the present invention can be applied to various electronic devices. The electronic device according to the one embodiment of the present invention includes the display device described above, and may further include modules or devices having additional functions in addition to the display device.

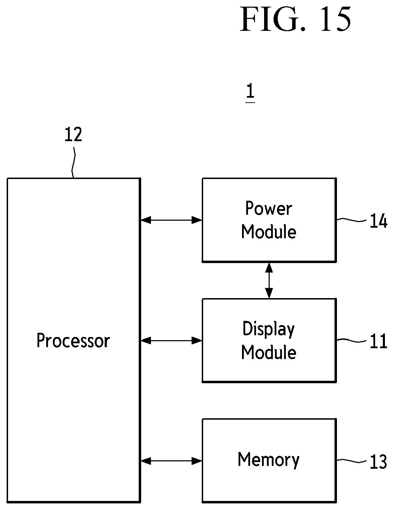

FIG. 15 is a block diagram of an electronic device according to one embodiment of the present invention.

Referring to FIG. 15, the electronic device 1 according to one embodiment of the present invention may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for the operation of the processor 12 or the display module 11. When the processor 12 executes an application stored in the memory 13, an image data signal and/or an input control signal is transmitted to the display module 11, and the display module 11 can process the received signal and output image information through a display screen.

The power module 14 may include a power supply module such as, for example a power adapter or a battery, and a power conversion module that converts the power supplied by the power supply module to generate power necessary for the operation of the electronic device 1.

At least one of the components of the electronic device 11 according to the one embodiment of the present invention may be included in the display device 10 according to the embodiments of the present invention. In addition, some modules of the individual modules functionally included in one module may be included in the display device 10, and other modules may be provided separately from the display device 10. For example, the display device 10 may include the display module 11, and the processor 12, the memory 13, and the power module 14 may be provided in the form of other devices within the electronic device 11 other than the display device 10.

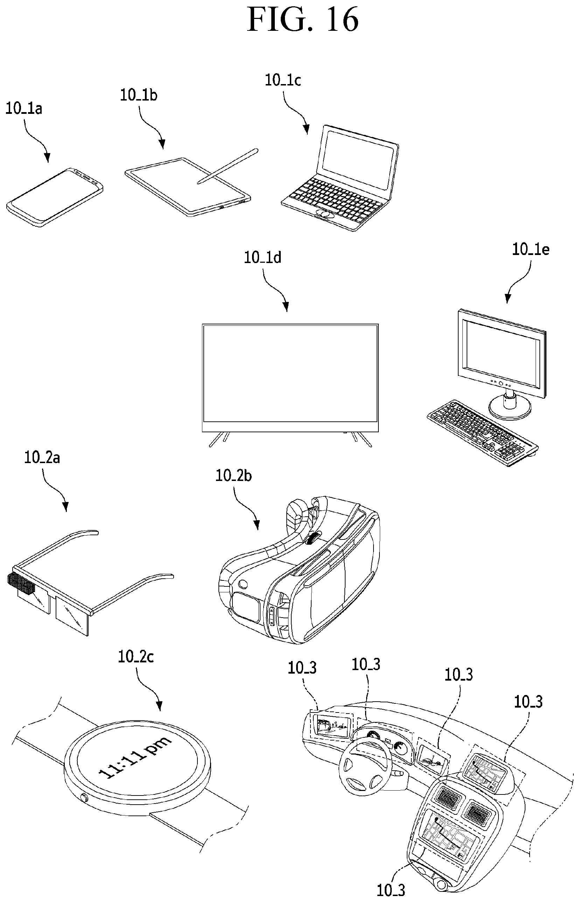

FIG. 16 is a schematic diagram of an electronic device according to various embodiments of the present invention.

Referring to FIG. 16, various electronic devices to which display devices 10 according to embodiments of the present invention are applied may include not only image display electronic devices such as a smart phone 10_1a, a tablet PC (personal computer) 10_1b, a laptop 10_1c, a TV 10_1d, and a desk monitor 10_1e, but also wearable electronic devices including display modules such as, for example smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

## Claims

1. A display device (10) comprising:
a substrate (100);
a light emitting element (ED) on the substrate (100);
a capping layer (300) comprising a first capping layer (310) arranged on the light emitting element (ED) and having a first refractive index, a second capping layer (350) arranged on the first capping layer (310) and having a second refractive index that is higher than the first refractive index, and a third capping layer (390) arranged on the second capping layer (350) and having a third refractive index that is lower than the second refractive index; and
a first encapsulation layer (510) arranged on the capping layer (300), a refractive index of the first encapsulation layer (510) being higher than the third refractive index of the third capping layer (390), and
wherein:
the first capping layer (310) and the second capping layer (350) comprise different materials,
the first refractive index of the first capping layer (310) is in a range of about 1.65 to about 1.80, and
a thickness (H1) of the first capping layer (310) is smaller than a thickness (H2) of the second capping layer (350) by about 20% or more.

2. The display device (10) as claimed in claim 1, wherein:
a difference value between the second refractive index and the first refractive index is about 0.2 or more, and
a difference value between the second refractive index and the third refractive index is about 0.2 or more.

3. The display device (10) as claimed in claim 1 or 2, wherein the second refractive index is in a range of about 1.9 to about 2.3.

4. The display device (10) as claimed in at least one of claims 1 to 3, wherein the third refractive index is in a range of about 1.65 to about 1.80.

5. The display device (10) as claimed in at least one of claims 1 to 4, wherein the first capping layer (310), the second capping layer (350), and the third capping layer (390) are formed by a thermal evaporation process.

6. The display device (10) as claimed in at least one of claims 1 to 5, wherein the first capping layer (310) and the third capping layer (390) comprise at least any one selected from among LiF, Liq, aluminum(III) bis(2-methyl-8-quinolinato)-4-phenylphenolate, and tris(8-hydroxyquinolinato)aluminium.

7. The display device (10) as claimed in at least one of claims 1 to 6, wherein the second capping layer (350) comprises at least any one selected from among tris(8-hydroxyquinolinato)aluminium, ZnSe, 2,5-bis(6'(2',2"-bipyridyl))-1,1-dimethyl-3,4-diphenylsilole, 4'-bis[N-(1-napthyl)-N-phenyl-amino] biphenyl, N,N'-diphenyl-N,N'-bis(3-methylphenyl)-1,1'-biphenyl-4,4'-diamine, and 1,1-bis[(di-4-tolylamino)phenyl]cyclohexane.

8. The display device (10) as claimed in at least one of claims 1 to 7, wherein:
a thickness (H1) of the first capping layer (310) is smaller than a thickness (H3) of the third capping layer (390), and
the thickness (H2) of the second capping layer (350) is greater than the thickness (H3) of the third capping layer (390).

9. The display device (10) as claimed in at least one of claims 1 to 8, wherein the first capping layer (310) has a thickness of about 7 nm to about 13 nm, and/or wherein the third capping layer (390) has a thickness of about 20 nm to about 30 nm, and/or wherein the second capping layer (350) has a thickness of about 35 nm to about 50 nm.

10. The display device (10) as claimed in at least one of claims 1 to 9, further comprising:
a second encapsulation layer (550) on the first encapsulation layer (510); and
a third encapsulation layer (590) on the second encapsulation layer (550),
wherein:
the second encapsulation layer (550) comprises an organic material, and
a refractive index of the second encapsulation layer (550) is lower than each of the refractive index of the first encapsulation layer (510) and a refractive index of the third encapsulation layer (590).

11. The display device (10) as claimed in at least one of claims 1 to 10, wherein the first encapsulation layer (510) comprises:
a first inorganic layer (511) arranged on the third capping layer (390) and having a fourth refractive index;
a second inorganic layer (513) arranged on the first inorganic layer (511) and having a fifth refractive index that is higher than the fourth refractive index;
a third inorganic layer (515) arranged on the second inorganic layer (513) and having a sixth refractive index that is higher than the fourth refractive index and lower than the fifth refractive index; and
a fourth inorganic layer (517) arranged on the third inorganic layer (515) and having a seventh refractive index that is lower than the sixth refractive index.

12. The display device (10) as claimed in claim 11, wherein:
the first inorganic layer (511) has a thickness in a range of about 55 nm to about 95 nm, and
the fourth refractive index of the first inorganic layer (511) is in a range of about 1.47 to about 1.67, and/or wherein:
the second inorganic layer (513) has a thickness in a range of about 40 nm to about 200 nm, and
the fifth refractive index of the second inorganic layer (513) is in a range of about 1.7 to about 2.0, and/or wherein:
the third inorganic layer (515) has a thickness in a range of about 500 nm to about 1100 nm, and
the sixth refractive index of the third inorganic layer (515) is in a range of about 1.52 to about 1.72, and/or wherein:
the fourth inorganic layer (517) has a thickness in a range of about 30 nm to about 110 nm, and
the seventh refractive index of the fourth inorganic layer (517) in a range of about 1.42 to about 1.62.

13. The display device (10) as claimed in claim 11 or 12, wherein the first inorganic layer (511), the second inorganic layer (513), the third inorganic layer (515), and the fourth inorganic layer (517) comprise at least any one selected from among silicon oxide, silicon nitride, and silicon oxynitride, and oxygen content of the fourth inorganic layer (517) is higher than oxygen content of each of the first inorganic layer (511), the second inorganic layer (513), and the third inorganic layer (515).

14. The display device (10) as claimed in at least one of claims 1 to 13, wherein:
the light emitting element (ED) comprises a first electrode (220) on the substrate (100), an intermediate layer (230) arranged on the first electrode (220) and comprising a light emitting layer (232) and a second electrode (240) on the intermediate layer (230), and
the first capping layer (310) is on the second electrode (240) to contact the second electrode (240).

15. An electronic device (1) comprising at least one display device (10) according to at least one of claims 1 to 14.
